# EUROPEAN PATENT APPLICATION

(11) **EP 1 882 952 A1**
(43) Date of publication of application: **30.01.2008**
(21) Application number: 06756363.5
(22) Date of filing: 19.05.2006
(51) Int. Cl.: G01R 1/073, H01L 21/66

(54) **WAFER INSPECTING SHEET-LIKE PROBE AND APPLICATION THEREOF**

(30) Priority: 19.05.2005 JP 2005146728
(71) Applicant: JSR Corporation, Tokyo 104-0045 (JP)
(72) Inventor: KIMURA, Kiyoshi c/o JSR MICROTECH INC., Saitama 3501236 (JP); HARA, Fujio c/o JSR MICROTECH INC., Saitama 3501236 (JP); YAMADA, Daisuke c/o JSR MICROTECH INC., Saitama 3501236 (JP)
(74) Representative: TBK-Patent
(86) International application number: PCT/JP2006/310007
(87) International publication number: WO 2006/123772

(57) **Abstract**

Disclosed herein are a sheet-like probe for wafer inspection, by which a good electrically connected state to a wafer can be surely achieved even when the pitch of electrodes to be inspected in the wafer is extremely small, and applications thereof.

The sheet-like probe for wafer inspection of the invention has an insulating sheet, in which a plurality of through-holes each extending in a thickness-wise direction of the insulating sheet have been formed in accordance with a pattern corresponding to a pattern of electrodes to be inspected in all or part of integrated circuits formed on a wafer, and electrode structures arranged in the respective through-holes in the insulating sheet so as to protrude from both surfaces of the insulating sheet. Each of the electrode structures is formed by linking a front-surface electrode part exposed to a front surface of the insulating sheet and having a diameter greater than a front surface-side opening diameter of the through-hole in the insulating sheet to a back-surface electrode part exposed to a back surface of the insulating sheet and having a diameter greater than a back surface-side opening diameter of the through-hole in the insulating sheet through a short circuit part inserted through into the through-hole in the insulating sheet, and is movable in the thickness-wise direction of the insulating sheet.

## Description

### TECHNICAL FIELD

The present invention relates to a sheet-like probe for wafer inspection, a probe member for wafer inspection, a probe card for wafer inspection and a wafer inspection apparatus, which are suitable for use in conducting electrical inspection of a plurality of integrated circuits formed on a wafer in a state of the wafer.

### BACKGROUND ART

In the production process of semiconductor integrated circuit devices, after a great number of integrated circuits are formed on a wafer composed of, for example, silicon, a probe test that basic electrical properties of each of these integrated circuits are inspected, thereby sorting defective integrated circuits is generally conducted. This wafer is then diced, thereby forming semiconductor chips. Such semiconductor chips are housed and sealed in respective proper packages. Each of the packaged semiconductor integrated circuit devices is further subjected to a burn-in test that electrical properties thereof are inspected under a high-temperature environment, thereby sorting semiconductor integrated circuit devices having latent defects.
In electrical inspection of integrated circuits, such as the probe test or burn-in test, a probe card having inspection electrodes arranged in accordance with a pattern corresponding to a pattern of electrodes to be inspected in an object of inspection is used for electrically connecting each of the electrodes to be inspected to a tester. As such a probe card, that, on which inspection electrodes (inspection probes) each composed of a pin or blade are arranged, has heretofore been used.

By the way, in the probe test conducted for integrated circuits formed on a wafer, a method that a wafer is divided into a plurality of areas, in each of which plural integrated circuits, for example, 16 integrated circuits have been formed, a probe test is performed collectively on all the integrated circuits formed in such an area, and the probe test is successively performed collectively on the integrated circuits formed in other areas has heretofore been adopted. In recent years, there has been a demand for collectively performing a probe test on a greater number of integrated circuits for the purpose of improving inspection efficiency and reducing inspection cost.
In the burn-in test on the other hand, it takes a long time to individually conduct burn-in test of a great number of integrated circuit devices because each integrated circuit device that is an object of inspection is fine, and its handling is inconvenient, whereby inspection cost becomes considerably high. From such reasons, in recent years, there has been proposed a WLBI (Wafer Level Burn-in) test in which the burn-in test is performed collectively on a great number of integrated circuits formed on a wafer.

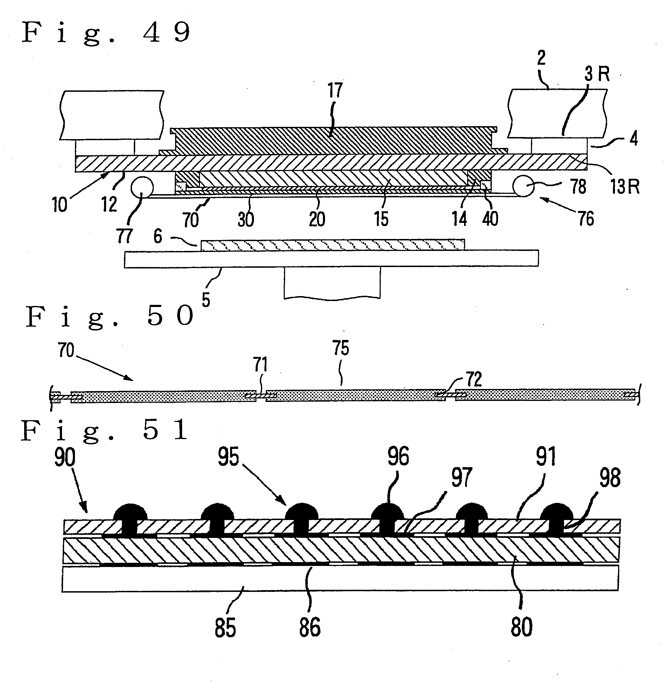

In order to produce a probe card used in such a probe test or WLBI test, it is however necessary to arrange a very great number of inspection probes, so that such a probe card is extremely expensive. In addition, when the number of electrodes to be inspected is great, and the pitch thereof is fine, it is difficult to produce the probe card itself.
From such reasons, there has been recently proposed, as illustrated in FIG. 51, a probe card having a circuit board 85 for inspection, on one surface of which a plurality of inspection electrodes 86 have been formed in accordance with a pattern corresponding to a pattern of electrodes to be inspected, an anisotropically conductive elastomer sheet 80 arranged on said one surface of this circuit board 85 for inspection and a sheet-like probe 90 arranged on this anisotropically conductive elastomer sheet 80 (for example, Patent Art. 1.).

The sheet-like probe 90 in such a probe card is constructed by an insulating sheet 91 and a plurality of electrode structures 95 arranged in this insulating sheet 91 in accordance with a pattern corresponding to the pattern of the electrodes to be inspected in a wafer that is an object of inspection and each extending through in a thickness-wise direction of the insulating sheet 91. Each of the electrode structures 95 is formed by integrally linking a projected front-surface electrode part 96 exposed to a front surface of the insulating sheet 91 to a plate-like back-surface electrode part 97 exposed to a back surface of the insulating sheet 91 through a short circuit part 98 extending through in the thickness-wise direction of the insulating sheet 91.

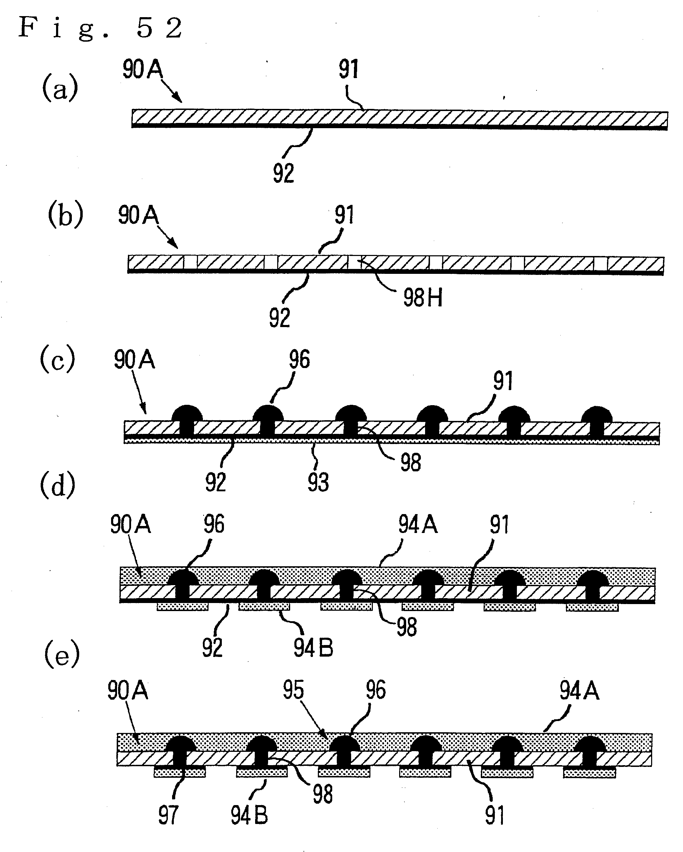

Such a sheet-like probe 90 is generally produced in the following manner.
As illustrated in FIG. 52(a), a laminate material 90A obtained by forming a metal layer 92 on one surface of an insulating sheet 91 is first provided, and through-holes 98H each extending through in a thickness-wise direction of the insulating sheet 91 are formed in the insulating sheet 91 by laser beam machining, dry etching or the like as illustrated in FIG. 52(b).
As illustrated in FIG. 52(c), a resist film 93 is then formed on the metal layer 92 on the insulating sheet 91, and an electroplating treatment is conducted by using the metal layer 92 as a common electrode, whereby a metal deposit is filled into each of the through-holes 98H in the insulating sheet 91 to form a short circuit part 98 integrally linking to the metal layer 92, and at the same time, a projected front-surface electrode part 96 integrally linking to the short circuit part 98 is formed on the front surface of the insulating sheet 91.
Thereafter, the resist film 93 is removed from the metal layer 92, and as illustrated in FIG. 52(d), a resist film 94A is formed on the front surface of the insulating sheet 91 including the front-surface electrode parts 96, and moreover resist film portions 94B are formed on the metal layer 92 in accordance with a pattern corresponding to a pattern of back-surface electrode parts to be formed. The metal layer 92 is subjected to an etching treatment to remove exposed portions of the metal layer 92, thereby forming back-surface electrode parts 97 as illustrated in FIG. 52(e), thus resulting in the formation of the electrode structures 95.
The resist film 94A is removed from the front surface of the insulating sheet 91, and at the same time the resist film portions 94B are removed from the back-surface electrode parts 97, thereby obtaining the sheet-like probe 90.

In the above-described probe card, the front-surface electrode parts 96 of the electrode structures 95 in the sheet-like probe 90 are arranged on the surface of a wafer that is an object of inspection, so as to be located on electrodes to be inspected of the wafer. In this state, the wafer is pressed by the probe card, whereby the anisotropically conductive elastomer sheet 80 is pressed by the back-surface electrode parts 97 of the electrode structures 95 in the sheet-like probe 90, and in the anisotropically conductive elastomer sheet 80, conductive paths are thereby formed between the back-surface electrode parts 97 and the inspection electrodes 86 of the circuit board 85 for inspection in the thickness-wise direction of the anisotropically conductive elastomer sheet 80. As a result, electrical connection of the electrodes to be inspected of the wafer to the inspection electrodes 86 of the circuit board 85 for inspection is achieved. In this state, necessary electrical inspection as to the wafer is then performed.
According to such a probe card, the anisotropically conductive elastomer sheet is deformed according to the degree of warpage of the wafer when the wafer is pressed by the probe card, so that good electrical connection to each of a great number of the electrodes to be inspected in the wafer can be surely achieved.

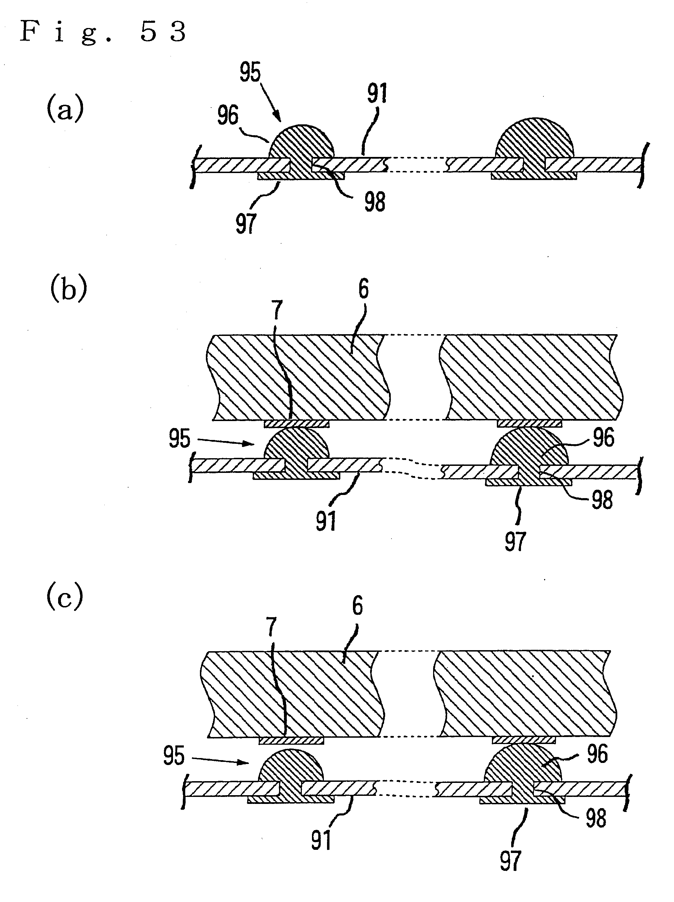

However, the above-described probe card involves the following problems.
Since it is difficult in fact to supply a current even in current density distribution to the overall surface of the metal layer 92 in the electroplating treatment step of forming the short circuit parts 98 and front-surface electrode parts 96 in the production process of the sheet-like probe 90, the growing rate of the plating layer varies with individual through-holes 98H in the insulating sheet 91 due to the unevenness of the current density distribution, so that a scatter occurs on the projected height of the front-surface electrode parts 96 formed as illustrated in FIG. 53(a). Upon conducting electrical connection of the sheet-like probe 90 to a wafer 6, the scatter of projected height in the front-surface electrode parts 96 is absorbed by the flexibility that the insulating sheet 91 has as illustrated in FIG. 53(b). In other words, the insulating sheet 91 is distorted according to the degree of scatter of the projected height in the front-surface electrode parts 96, whereby the electrode structures 95 are displaced, so that each of the front-surface electrode parts 96 comes into contact with each of electrodes 7 to be inspected, thereby achieving necessary electrical connection.
However, when the arrangement pitch of the electrodes 7 to be inspected in the wafer 6 is small, i.e., the arrangement pitch of the electrode structures 95 in the sheet-like probe 90 is small, a ratio of a clearance between electrode structures 95 adjoining each other to the thickness of the insulating sheet 91 becomes small, so that the flexibility of the whole sheet-like probe 90 is greatly lowered. As a result, the scatter of projected height in the front-surface electrode parts 96 is not sufficiently absorbed upon conducting electrical connection of the sheet-like probe 90 to the wafer 6 as illustrated in FIG. 53(c). In other words, the electrode structure 95 is not sufficiently displaced, so that, for example, a front-surface electrode part 96 (in the drawing, a left-side front-surface electrode part 96) smaller in projected height comes into no contact with the electrode 7 to be inspected, and so it is thus difficult to achieve stable electrical connection to the electrode 7 to be inspected.

Patent Art. 1: Japanese Patent Application Laid-Open No. 2001-15565

### DISCLOSURE OF THE INVENTION

The present invention has been made on the basis of the foregoing circumstances and has as its object the provision of a sheet-like probe for wafer inspection, a probe member for wafer inspection, a probe card for wafer inspection and a wafer inspection apparatus, by which a good electrically connected state to a wafer, which is an object of inspection, can be surely achieved even when the pitch of electrodes to be inspected in the wafer is extremely small.

A sheet-like probe for wafer inspection according to the present invention comprises an insulating sheet, in which a plurality of through-holes each extending in a thickness-wise direction of the insulating sheet have been formed in accordance with a pattern corresponding to a pattern of electrodes to be inspected in all or part of integrated circuits formed on a wafer, which is an object of inspection, and
electrode structures arranged in the respective through-holes in the insulating sheet so as to protrude from both surfaces of the insulating sheet,
wherein each of the electrode structures is formed by linking a front-surface electrode part exposed to a front surface of the insulating sheet and having a diameter greater than a front surface-side opening diameter of the through-hole in the insulating sheet to a back-surface electrode part exposed to a back surface of the insulating sheet and having a diameter greater than a back surface-side opening diameter of the through-hole in the insulating sheet through a short circuit part inserted through into the through-hole in the insulating sheet, and is movable in the thickness-wise direction of the insulating sheet.

A probe member for wafer inspection according to the present invention comprises the above-described sheet-like probe for wafer inspection, and an anisotropically conductive connector arranged on a back surface of the sheet-like probe for wafer inspection.

A probe card for wafer inspection according to the present invention comprises a circuit board for inspection, on the front surface of which a plurality of inspection electrodes have been formed in accordance with a pattern corresponding to a pattern of electrodes to be inspected in all or part of integrated circuits formed on a wafer, which is an object of inspection, an anisotropically conductive connector arranged on the front surface of the circuit board for inspection, and a sheet-like probe for wafer inspection, which is arranged on the anisotropically conductive connector,
wherein the sheet-like probe for wafer inspection comprises an insulating sheet, in which a plurality of through-holes each extending in a thickness-wise direction of the insulating sheet have been formed in accordance with the pattern corresponding to the pattern of the electrodes to be inspected, and electrode structures arranged in the respective through-holes in the insulating sheet so as to protrude from both surfaces of the insulating sheet, and
wherein each of the electrode structures is formed by linking a front-surface electrode part exposed to a front surface of the insulating sheet and having a diameter greater than a front surface-side opening diameter of the through-hole in the insulating sheet to a back-surface electrode part exposed to a back surface of the insulating sheet and having a diameter greater than a back surface-side opening diameter of the through-hole in the insulating sheet through a short circuit part extending through in the through-hole in the insulating sheet, and is movable in the thickness-wise direction of the insulating sheet.

In the probe card for wafer inspection according to the present invention, a movable distance of each electrode structure in the thickness-wise direction of the insulating sheet may preferably be 5 to 50 µm.
In addition, the insulating sheet may preferably be composed of a material having a coefficient of linear thermal expansion of at most 3 x 10⁻⁵/K.
Further, it may be preferable that the anisotropically conductive connector be composed of a frame plate, in which a plurality of openings have been formed corresponding to electrode regions, in which the electrodes to be inspected in all or part of the integrated circuits formed on the wafer, which is the object of inspection, have been formed, and a plurality of elastic anisotropically conductive films arranged in and supported by the frame plate so as to close the respective openings, and the elastic anisotropically conductive films each have conductive parts for connection arranged in accordance with a pattern corresponding to a pattern of the electrodes to be inspected in the electrode region and formed by causing conductive particles exhibiting magnetism to be contained in an elastic polymeric substance, and an insulating part mutually insulating these conductive parts for connection and composed of the elastic polymeric substance.

A wafer inspection apparatus according to the present invention is a wafer inspection apparatus for conducting electrical inspection of each of a plurality of integrated circuits formed on a wafer in a state of the wafer, which comprises the above-described probe card for wafer inspection.

According to the probe card for wafer inspection of the present invention, each of the electrode structures in the sheet-like probe for wafer inspection is provided movably in the thickness-wise direction of the insulating sheet, so that even when a scatter occurs on the projected height of the front-surface electrode parts in the electrode structures, each of the electrode structures moves in the thickness-wise direction of the insulating sheet according to the projected height of the front-surface electrode part thereof when the electrodes to be inspected are pressurized. Accordingly, a good electrically connected state to the wafer can be surely achieved.
Further, the front-surface electrode parts and back-surface electrode parts each have a diameter greater than the front surface-side opening diameter and back surface-side opening diameter of the through-hole in the insulating sheet, so that the front-surface electrode parts and back-surface electrode parts each function as a stopper. As a result, the electrode structures can be prevented from falling off from the insulating sheet.
Further, that having a low coefficient of linear thermal expansion is used as a resin material forming the insulating sheet, whereby positional deviation between the electrode structures and the electrodes to be inspected due to thermal expansion of the insulating sheet can be inhibited.
In addition, in the anisotropically conductive connector, the elastic anisotropically conductive films are respectively arranged in a plurality of the openings formed in the frame plate and supported by the frame plate, whereby each of the elastic anisotropically conductive films may be small in area. Since the elastic anisotropically conductive film small in area is little in the absolute quantity of thermal expansion in a plane direction thereof, positional deviation of the conductive parts for connection to the inspection electrodes and electrode structures by temperature change can be inhibited.
Accordingly, a good electrically connected state to the wafer can be stably retained in inspection of the wafer.

### BRIEF DESCRIPTION OF THE DRAWINGS

[Fig. 1] is a cross-sectional view illustrating the construction of a first exemplary probe card according to the present invention.
[FIG. 2] is a cross-sectional view illustrating, on an enlarged scale, the construction of a principal part of the first exemplary probe card.
[FIG. 3] is a plan view illustrating a circuit board for inspection in the first exemplary probe card.
[FIG. 4] illustrates, on an enlarged scale, a lead electrode part in the circuit board for inspection.
[FIG. 5] is a plan view of an anisotropically conductive connector in the first exemplary probe card.
[FIG. 6] is a cross-sectional view illustrating, on an enlarged scale, an elastic anisotropically conductive film in the anisotropically conductive connector.
[FIG. 7] is a cross-sectional view illustrating the construction of a sheet-like probe in the first exemplary probe card.
[FIG. 8] is a cross-sectional view illustrating, on an enlarged scale, the construction of a principal part of the sheet-like probe.
[FIG. 9] is a cross-sectional view illustrating the construction of a laminate material for producing the sheet-like probe.
[FIG. 10] is a cross-sectional view illustrating a state that openings have been formed in a metal layer in the laminate material.
[FIG. 11] is a cross-sectional view illustrating a state that through-holes have been formed in an insulating sheet in the laminate material.
[FIG. 12] is a cross-sectional view illustrating the construction of a composite laminate material.
[FIG. 13] is a cross-sectional view illustrating a state that a resist film has been formed on the composite laminate material.
[FIG. 14] is a cross-sectional view illustrating a state that electrode structures have been formed in through-holes in the insulating sheet in the composite laminate material.
[FIG. 15] is a cross-sectional view illustrating a state that the resist film has been removed from the composite laminate material.
[FIG. 16] is a cross-sectional view illustrating the construction of a second exemplary probe card according to the present invention.
[FIG. 17] is a cross-sectional view illustrating, on an enlarged scale, the construction of a principal part of the second exemplary probe card.
[FIG. 18] is a plan view illustrating a circuit board for inspection in the second exemplary probe card. [FIG. 19] is a plan view of an anisotropically conductive connector in the second exemplary probe card.
[FIG. 20] is a cross-sectional view illustrating the construction of a first exemplary wafer inspection apparatus according to the present invention.
[FIG. 21] is a cross-sectional view illustrating, on an enlarged scale, the construction of a principal part of the first exemplary wafer inspection apparatus.
[FIG. 22] is a cross-sectional view illustrating, on an enlarged scale, a connector in the first exemplary wafer inspection apparatus.
[FIG. 23] is a cross-sectional view illustrating the construction of a second exemplary wafer inspection apparatus according to the present invention.
[FIG. 24] is a cross-sectional view illustrating the construction of a principal part of another exemplary sheet-like probe.
[FIG. 25] is a cross-sectional view illustrating the construction of a laminate material for producing the sheet-like probe shown in FIG. 24.
[FIG. 26] is a cross-sectional view illustrating a state that through-holes have been formed in the laminate material shown in FIG. 25.
[FIG. 27] is a cross-sectional view illustrating a state that thin metal layers have been formed on the surface of the laminate material and the inner wall surfaces of the through-holes.
[FIG. 28] is a cross-sectional view illustrating a state that posts for electrode structure have been formed in the through-holes in the laminate material.
[FIG. 29] is a cross-sectional view illustrating the construction of a composite material.
[FIG. 30] is a cross-sectional view illustrating a state that an insulating sheet has been arranged on a cushioning material.
[FIG. 31] is a cross-sectional view illustrating a state that the composite material has been arranged on the insulating sheet.
[FIG. 32] is a cross-sectional view illustrating a state that through-holes have been formed in the insulating sheet.
[FIG. 33] is a cross-sectional view illustrating a state that end surfaces of the posts for electrode structure have been exposed.
[FIG. 34] is a cross-sectional view illustrating a state that electrode structures have been formed.
[FIG. 35] is a cross-sectional view illustrating a state that a metal foil and the thin metal layers have been exposed.
[FIG. 36] is a cross-sectional view illustrating the construction of a principal part of a further exemplary sheet-like probe.
[FIG. 37] is a cross-sectional view illustrating the construction of a laminate material for producing the sheet-like probe shown in FIG. 36.
[FIG. 38] is a cross-sectional view illustrating a state that through-holes have been formed in the laminate material shown in FIG. 37.
[FIG. 39] is a cross-sectional view illustrating a state that thin metal layers have been formed on the surface of the laminate material and the inner wall surfaces of the through-holes.
[FIG. 40] is a cross-sectional view illustrating a state that posts for electrode structure have been formed in the through-holes in the laminate material.
[FIG. 41] is a cross-sectional view illustrating the construction of a composite material.
[FIG. 42] is a cross-sectional view illustrating a state that a resist layer has been formed on a front surface of an insulating sheet.
[FIG. 43] is a cross-sectional view illustrating a state that the composite material has been arranged on a back surface of the insulating sheet.
[FIG. 44] is a cross-sectional view illustrating a state that through-holes have been formed in the insulating sheet.
[FIG. 45] is a cross-sectional view illustrating a state that end surfaces of the posts for electrode structure have been exposed.
[FIG. 46] is a cross-sectional view illustrating a state that electrode structures have been formed.
[FIG. 47] is a cross-sectional view illustrating a state that a metal foil and the thin metal layers have been exposed.
[FIG. 48] is a cross-sectional view illustrating the construction of a principal part of a further exemplary probe card according to the present invention.
[FIG. 49] is a cross-sectional view illustrating the construction of a further exemplary wafer inspection apparatus according to the present invention.
[FIG. 50] is a cross-sectional view illustrating the construction of a anisotropically conductive connector used in the wafer inspection apparatus shown in FIG. 49.
[FIG. 51] is a cross-sectional view illustrating the construction of an exemplary conventional probe card.
[FIG. 52] is a cross-sectional view illustrating a process for producing a sheet-like probe in the conventional probe card.
[FIG. 53](a) is a cross-sectional view illustrating, on an enlarged scale, electrode structures in the sheet-like probe in the conventional probe card, (b) is a cross-sectional view illustrating a state that front-surface electrode parts have come into contact with respective electrodes to be inspected of a wafer, and (c) is a cross-sectional view illustrating a state that a contact failure has occurred between the front-surface electrode part and the electrode to be inspected.

### DESCRIPTION OF CHARACTERS

- 2: Controller
- 3: Input-output terminals
- 3R: Input-output terminal part
- 4: Connector
- 4A: Conductive pins
- 4B: Supporting member
- 5: Wafer mounting table
- 6: Wafer
- 7: Electrodes to be inspected
- 10: Probe card
- 10A: Probe member
- 11: Circuit board for inspection
- 12: First base element
- 13: Lead electrodes
- 13R: Lead electrode part
- 14: Holder
- 14K: Opening
- 14S: Step portion
- 15: Second base element
- 16: Inspection electrodes
- 16R: Inspection electrode part
- 17: Reinforcing member
- 20: Anisotropically conductive connector
- 21: Frame plate
- 22: Openings
- 23, 23A: Elastic anisotropically conductive films
- 24: Conductive parts for connection
- 25: Insulating parts
- 26: Functional parts
- 27: Projected parts
- 28: Parts to be supported
- 29: Anisotropically conductive elastomer sheet
- 30: Sheet-like probe
- 30A: Composite laminate material
- 30B: Laminate material
- 31: Insulating sheet
- 31H: Openings
- 32: Electrode structures
- 32a: Front-surface electrode parts
- 32b: Back-surface electrode parts
- 32c: Short circuit parts
- 32p: Posts for electrode structure
- 33A: Metal layer
- 33B: Thin metal layers
- 33K: Openings
- 34, 35: Resist layers
- 34H, 35H: Pattern holes
- 40: Holding member
- 50: Composite material
- 50A: Laminate material
- 50H: Through-holes
- 51: Metal foil
- 51H: Through-holes
- 52, 53: Resist layers
- 52H, 53H: Through-holes
- 54, 55: Resin sheets
- 54H, 55H: Through-holes
- 56: Thin metal layer
- 57: Cushioning material
- 60: Composite material
- 60A: Laminate material
- 60H: Through-holes
- 61H: Through-holes
- 61: Metal foil
- 62, 63: Resist layers
- 62H, 63H: Through-holes
- 64, 65: Resin sheets
- 64H, 65H: Through-holes
- 66: Thin metal layer
- 67: Resist layer
- 70: Anisotropically conductive connector
- 71: Support
- 72: Openings
- 75: Anisotropically conductive elastomer sheet
- 76: Moving mechanism
- 77: Unwind roller
- 78: Take-up roller
- 80: Anisotropically conductive elastomer sheet
- 85: Circuit board for inspection
- 86: Inspection electrodes
- 90: Sheet-like probe
- 90A: Laminate material
- 91: Insulating sheet
- 92: Metal layer
- 93: Resist film
- 94A, 94B: Resist films
- 95: Electrode structures
- 96: Front-surface electrode parts
- 97: Back-surface electrode parts
- 98: Short circuit parts
- 98H: Through-holes
- P: Conductive particles

### BEST MODE FOR CARRYING OUT THE INVENTION

The embodiments of the present invention will hereinafter be described in detail.

### <Probe card for wafer inspection>

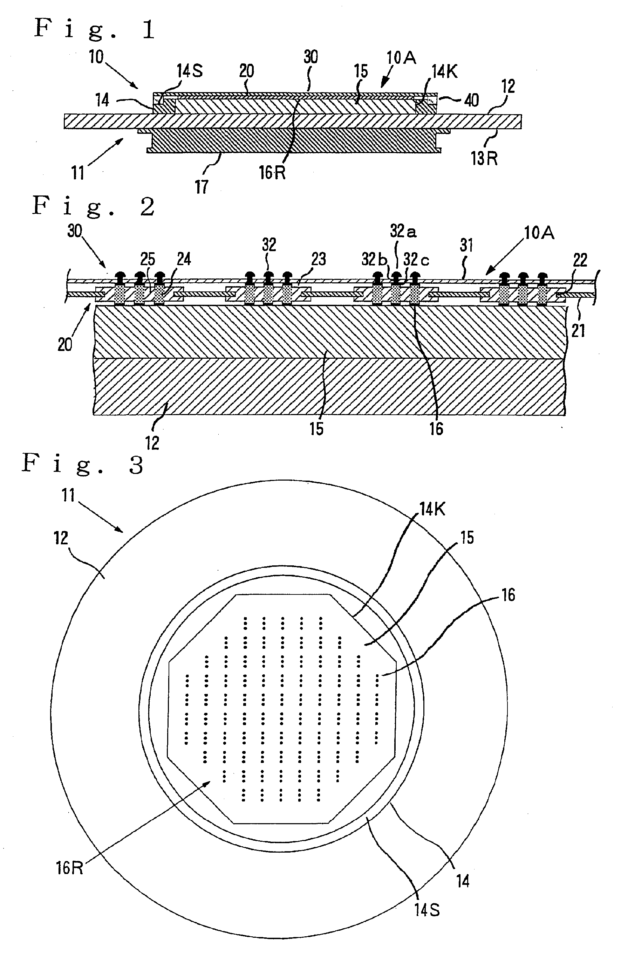

FIG. 1 is a cross-sectional view illustrating the construction of a first exemplary probe card for wafer inspection (hereinafter referred to as "probe card" merely) according to the present invention, and
FIG. 2 is a cross-sectional view illustrating the construction of a principal part of the first exemplary probe card.
   This first exemplary probe card 10 is used for collectively conducting a burn-in test on, for example, a wafer, on which a plurality of integrated circuits have been formed, as to each of the integrated circuits in a state of the wafer, and is constructed by a circuit board 11 for inspection and a probe member 10A for wafer inspection (hereinafter referred to as "probe member" merely), which is arranged on one surface (upper surface in FIG. 1 and FIG. 2) of this circuit board 11 for inspection, and the probe member 10A is constructed by a sheet-like probe 30 for wafer inspection (hereinafter referred to as "sheet-like probe" merely) and an anisotropically conductive connector 20 arranged on a back surface of this sheet-like probe 30.

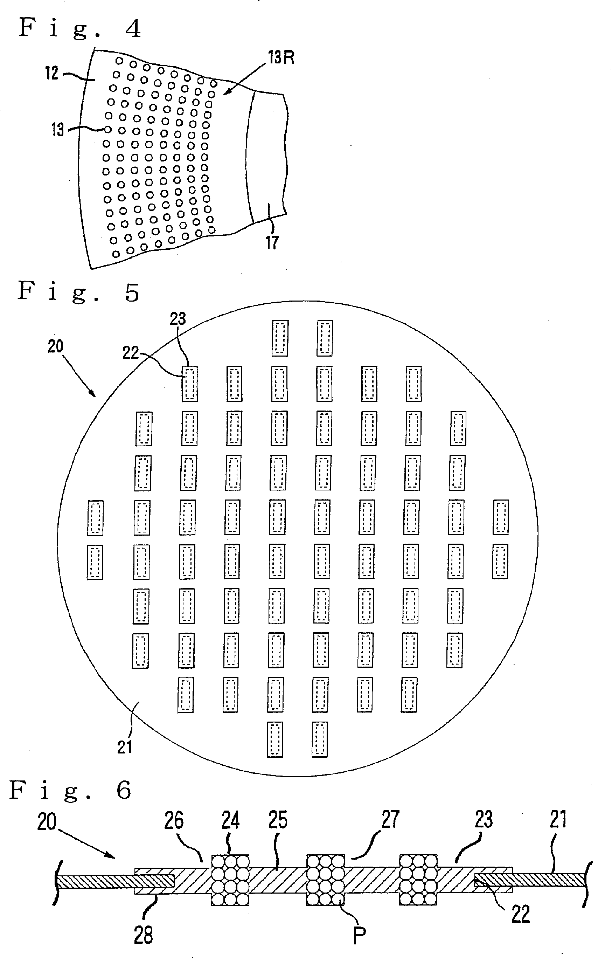

As also illustrated in FIG. 3, the circuit board 11 for inspection has a disk-like first base element 12, and a regular-octagonal plate-like second base element 15 is arranged at a central portion on a front surface (upper surface in FIG. 1 and FIG. 2) of this first base element 12. This second base element 15 is held by a holder 14 fixed to the front surface of the first base element 12. Further, a reinforcing member 17 is provided at a central portion on a back surface of the first base element 12.
A plurality of connection electrodes (not illustrated) are formed in accordance with a proper pattern at a central portion on the front surface of the first base element 12. On the other hand, as illustrated in FIG. 4, a lead electrode part 13R, in which a plurality of lead electrodes 13 are arranged so as to align along a circumferential direction of the first base element 12, is formed at a peripheral edge portion on the back surface of the first base element 12. A pattern of the lead electrodes 13 is a pattern corresponding to a pattern of input-output terminals of a controller in a wafer inspection apparatus, which will be described subsequently. Each of the lead electrodes 13 is electrically connected to its corresponding connection electrode through an internal wiring (not illustrated).
An inspection electrode part 16R, in which a plurality of inspection electrodes 16 are arranged in accordance with a pattern corresponding to a pattern of electrodes to be inspected in all integrated circuits formed on a wafer, which is an object of inspection, is formed on a front surface (upper surface in FIG. 1 and FIG. 2) of the second base element 15. On the other hand, a plurality of terminal electrodes (not illustrated) are arranged in accordance with a proper pattern on a back surface of the second base element 15, and each of the terminal electrodes is electrically connected to its corresponding inspection electrode through an internal wiring (not illustrated).
The connection electrodes of the first base element 12 are electrically connected to their corresponding terminal electrodes of the second base element 15 through a proper means.

As a base material for forming the first base element 12 in the circuit board 11 for inspection, may be used any of conventionally known various base materials, and specific examples thereof include composite resin base materials such as glass fiber-reinforced epoxy resins, glass fiber-reinforced phenol resins, glass fiber-reinforced polyimide resins and glass fiber-reinforced bismaleimide triazine resins.
As a material for forming the second base element 15 in the circuit board 11 for inspection, is preferably used a material having a coefficient of linear thermal expansion of at most 3 x 10⁻⁵/K, more preferably 1 x 10⁻⁷ to 1 x 10⁻⁵/K, particularly preferably 1 x 10⁻⁶ to 6 x 10⁻⁶/K. Specific examples of such a base material include inorganic base materials composed of Pyrex (trademark) glass, quartz glass, alumina, beryllia, silicon carbide, aluminum nitride, boron nitride or the like, and laminated base materials obtained by using a metal plate formed of an iron-nickel alloy steel such as 42 alloy, covar or invar as a core material and laminating a resin such as an epoxy resin or polyimide resin thereon.

The holder 14 has a regular-octagonal opening 14K fitted to the external shape of the second base element 15, and the second base element 15 is housed in this opening 14K. A peripheral edge of the holder 14 is circular, and a step portion 14S is formed at the peripheral edge of the holder 14 along a circumferential direction thereof.

The anisotropically conductive connector 20 in the probe member 10A has a disk-like frame plate 21, in which a plurality of openings 22 each extending through in a thickness-wise direction of the frame plate have been formed, as illustrated in FIG. 5. The openings 22 in this frame plate 21 are formed corresponding to a pattern of electrode regions, in which electrodes to be inspected in all integrated circuits formed on the wafer, which is the object of inspection, have been formed. In the frame plate 21, a plurality of elastic anisotropically conductive films 23 having conductivity in a thickness-wise direction thereof are arranged in a state supported by their corresponding opening edges of the frame plate 21 so as to close the respective openings 22.

Each of the elastic anisotropically conductive films 23 is formed of an elastic polymeric substance as a base material and has a functional part 26 composed of a plurality of conductive parts 24 for connection extending in a thickness-wise direction of the film and an insulating part 25 formed around the conductive parts 24 for connection and mutually insulating the conductive parts 24 for connection as also illustrated on an enlarged scale in FIG. 6. The functional part 26 is arranged so as to be located in the opening 22 of the frame plate 21. The conductive parts 24 for connection in this functional part 26 are arranged in accordance with a pattern corresponding to a pattern of the electrodes to be inspected in an electrode region of an integrated circuit formed on the wafer, which is the object of inspection.
At a peripheral edge of the functional part 26, a part 28 to be supported, which is fixed to and supported by an edge portion of the opening in the frame plate 21, is formed integrally and continuously with the functional part 26. More specifically, the part 28 to be supported in this embodiment is shaped in a forked form and fixed and supported in a closely contacted state so as to grasp the edge portion of the opening in the frame plate 21.
In the conductive parts 24 for connection in the functional part 26 of the elastic anisotropically conductive film 23, conductive particles P exhibiting magnetism are densely contained in a state oriented so as to align in the thickness-wise direction. On the other hand, the insulating part 25 does not contain the conductive particles P at all or scarcely contains them.
In the illustrated embodiment, projected parts 27 protruding from other surfaces than portions, at which the conductive parts 24 and peripheral portions thereof are located, are formed at those portions on both surfaces of the functional part 26 in the elastic anisotropically conductive film 23.

The thickness of the frame plate 21 varies according to the material thereof, but is preferably 20 to 600 µm, more preferably 40 to 400 µm.
If this thickness is smaller than 20 µm, the strength required upon use of the resulting anisotropically conductive connector 20 is not achieved, and the durability thereof is liable to become low. In addition, such stiffness as the form of the frame plate 21 is retained is not achieved, and the handling property of the anisotropically conductive connector 20 becomes low. If the thickness exceeds 600 µm on the other hand, the elastic anisotropically conductive films 23 formed in the openings 22 become too great in thickness, and it may be difficult in some cases to achieve good conductivity in the conductive parts 24 for connection and insulating property between adjoining conductive parts 24 for connection.
The form and size in a plane direction of the openings 22 in the frame plate 21 are designed according to the size, pitch and pattern of electrodes to be inspected in a wafer that is an object of inspection.

No particular limitation is imposed on a material for forming the frame plate 21 so far as it has such stiffness as the resulting frame plate 21 is hard to be deformed, and the form thereof is stably retained. For example, various kinds of materials such as metallic materials, ceramic materials and resin materials may be used. When the frame plate 21 is formed by, for example, a metallic material, an insulating film may also be formed on the surface of the frame plate 21.
Specific examples of the metallic material for forming the frame plate 21 include metals such as iron, copper, nickel, titanium and aluminum, and alloys or alloy steels composed of a combination of at least two of these metals.

As the material for forming the frame plate 21, is preferably used a material having a coefficient of linear thermal expansion of at most 3 x 10⁻⁵/K, more preferably -1 x 10⁻⁷ to 1 x 10⁻⁵/K, particularly preferably 1 x 10⁻⁶ to 8 x 10⁻⁶/K.
Specific examples of such a material include invar alloys such as invar, Elinvar alloys such as Elinvar, and alloys or alloy steels such as superinvar, covar and 42 alloy.

The overall thickness (thickness of the conductive part 24 for connection in the illustrated embodiment) of the elastic anisotropically conductive film 23 is preferably 50 to 3,000 µm, more preferably 70 to 2,500 µm, particularly preferably 100 to 2,000 µm. When this thickness is 50 µm or greater, elastic anisotropically conductive films 23 having sufficient strength are provided with certainty. When this thickness is 3,000 µm or smaller on the other hand, conductive parts 23 for connection having necessary conductive properties are provided with certainty.
The projected height of the projected parts 27 is preferably at least 10% in total of the thickness of such projected parts 27, more preferably at least 20%. Projected parts 27 having such a projected height are formed, whereby the conductive parts 24 for connection are sufficiently compressed by small pressurizing force, so that good conductivity is surely achieved.
The projected height of the projected parts 27 is preferably at most 100%, more preferably at most 70% of the shortest width or diameter of each projected part 27. Projected parts 27 having such a projected height are formed, whereby the projected parts 27 are not buckled when they are pressurized, so that the expected conductivity is surely achieved.
The thickness (thickness of one of the forked portions in the illustrated embodiment) of the part 28 to be supported is preferably 5 to 600 µm, more preferably 10 to 500 µm, particularly preferably 20 to 400 µm.
It is not essential that the part 28 to be supported is formed in the forked form, and the elastic anisotropically conductive film may also be fixed to only one surface of the frame plate 21.

The elastic polymeric substance forming the anisotropically conductive films 23 is preferably a heat-resistant polymeric substance having a crosslinked structure. Various materials may be used as curable polymeric substance-forming materials usable for obtaining such crosslinked polymeric substances. Specific examples thereof include silicone rubber; conjugated diene rubbers such as polybutadiene rubber, natural rubber, polyisoprene rubber, styrene-butadiene copolymer rubber and acrylonitrile-butadiene copolymer rubber, and hydrogenated products thereof; block copolymer rubbers such as styrene-butadiene-diene block terpolymer rubber and styrene-isoprene block copolymers, and hydrogenated products thereof; and besides chloroprene, urethane rubber, polyester rubber, epichlorohydrin rubber, ethylene-propylene copolymer rubber, ethylene-propylene-diene terpolymer rubber and soft liquid epoxy rubber.
Among these, silicone rubber is preferred from the viewpoints of molding and processing ability and electrical properties.

As the silicone rubber, is preferred that obtained by crosslinking or condensing liquid silicone rubber. The liquid silicone rubber preferably has a viscosity not higher than 10⁵ poises as measured at a shear rate of 10⁻¹ sec and may be any of condensation type, addition type and those containing a vinyl group or hydroxyl group. As specific examples thereof, may be mentioned dimethyl silicone raw rubber, methylvinyl silicone raw rubber and methylphenylvinyl silicone raw rubber.

Among these, vinyl group-containing liquid silicone rubber (vinyl group-containing dimethyl polysiloxane) is generally obtained by subjecting dimethyldichlorosilane or dimethyldialkoxysilane to hydrolysis and condensation reaction in the presence of dimethylvinylchlorosilane or dimethylvinyl-alkoxysilane and then fractionating the reaction product by, for example, repeated dissolution-precipitation.
Liquid silicone rubber having vinyl groups at both terminals thereof is obtained by subjecting a cyclic siloxane such as octamethylcyclotetrasiloxane to anionic polymerization in the presence of a catalyst, using, for example, dimethyldivinylsiloxane as a polymerization terminator and suitably selecting other reaction conditions (for example, amounts of the cyclic siloxane and polymerization terminator). As the catalyst for the anionic polymerization herein, may be used an alkali such as tetramethylammonium hydroxide or n-butylphosphonium hydroxide, or a silanolate solution thereof. The reaction is conducted at a temperature of, for example, 80 to 130°C.
Such a vinyl group-containing dimethyl polysiloxane preferably has a molecular weight Mw (weight average molecular weight as determined in terms of standard polystyrene; the same shall apply hereinafter) of 10,000 to 40,000. It also preferably has a molecular weight distribution index (a ratio Mw/Mn of a weight average molecular weight Mw as determined in terms of standard polystyrene to a number average molecular weight Mn as determined in terms of standard polystyrene; the same shall apply hereinafter) of at most 2 from the viewpoint of the heat resistance of the resulting elastic anisotropically conductive films 23.

On the other hand, hydroxyl group-containing liquid silicone rubber (hydroxyl group-containing dimethyl polysiloxane) is generally obtained by subjecting dimethyldichlorosilane or dimethyldialkoxysilane to hydrolysis and condensation reaction in the presence of dimethylhydrochlorosilane or dimethylhydroalkoxysilane and then fractionating the reaction product by, for example, repeated dissolution-precipitation.
The hydroxyl group-containing liquid silicone rubber is also obtained by subjecting a cyclic siloxane to anionic polymerization in the presence of a catalyst, using, for example, dimethylhydrochlorosilane, methyldihydrochlorosilane or dimethylhydroalkoxysilane as a polymerization terminator and suitably selecting other reaction conditions (for example, amounts of the cyclic siloxane and polymerization terminator). As the catalyst for the anionic polymerization herein, may be used an alkali such as tetramethylammonium hydroxide or n-butylphosphonium hydroxide or a silanolate solution thereof. The reaction is conducted at a temperature of, for example, 80 to 130°C.

Such a hydroxyl group-containing dimethyl polysiloxane preferably has a molecular weight Mw of 10,000 to 40,000. It also preferably has a molecular weight distribution index of at most 2 from the viewpoint of the heat resistance of the resulting elastic anisotropically conductive films 23.
In the present invention, any one of the above-described vinyl group-containing dimethyl polysiloxane and hydroxyl group-containing dimethyl polysiloxane may be used, or both may also be used in combination.

A curing catalyst for curing the polymeric substance-forming material may be contained in the polymeric substance-forming material. As such a curing catalyst, may be used an organic peroxide, fatty acid azo compound, hydrosilylation catalyst or the like.
Specific examples of the organic peroxide used as the curing catalyst include benzoyl peroxide, bisdicyclobenzoyl peroxide, dicumyl peroxide and di-tert-butyl peroxide.
Specific examples of the fatty acid azo compound used as the curing catalyst include azobisisobutyronitrile.
Specific examples of that used as the catalyst for hydrosilylation reaction include publicly known catalysts such as platinic chloride and salts thereof, platinum-unsaturated group-containing siloxane complexes, vinylsiloxane-platinum complexes, platinum-1,3-divinyltetramethyldisiloxane complexes, complexes of triorganophosphine or phosphite and platinum, acetyl acetate platinum chelates, and cyclic diene-platinum complexes.
The amount of the curing catalyst used is suitably selected in view of the kind of the polymeric substance-forming material, the kind of the curing catalyst and other curing treatment conditions. However, it is generally 3 to 15 parts by weight per 100 parts by weight of the polymeric substance-forming material.

As the conductive particles P contained in the conductive parts 24 for connection in the elastic anisotropically conductive films 23, those exhibiting magnetism are preferably used in that such conductive particles P can be easily moved in a molding material for forming the elastic anisotropically conductive films 23 in the formation of the elastic anisotropically conductive films 23. Specific examples of such conductive particles P exhibiting magnetism include particles of metals exhibiting magnetism, such as iron, nickel and cobalt, particles of alloys thereof, particles containing such a metal, particles obtained by using these particles as core particles and plating surfaces of the core particles with a metal having good conductivity, such as gold, silver, palladium or rhodium, particles obtained by using particles of a non-magnetic metal, particles of an inorganic substance, such as glass beads, or particles of a polymer as core particles and plating surfaces of the core particles with a conductive magnetic substance such as nickel or cobalt, and particles obtained by coating the core particles with both conductive magnetic substance and good-conductive metal.
Among these, particles obtained by using nickel particles as core particles and plating their surfaces with a metal having good conductivity, such as gold or silver are preferably used.
No particular limitation is imposed on a means for coating the surfaces of the core particles with the conductive metal. However, the coating may be conducted by, for example, electroless plating.

When those obtained by coating the surfaces of the core particles with the conductive metal are used as the conductive particles P, the coating rate (proportion of an area coated with the conductive metal to the surface area of the core particles) of the conductive metal on the particle surfaces is preferably at least 40%, more preferably at least 45%, particularly preferably 47 to 95% from the viewpoint of achieving good conductivity.
The amount of the conductive metal to coat is preferably 2.5 to 50% by weight, more preferably 3 to 45% by weight, still more preferably 3.5 to 40% by weight, particularly preferably 5 to 30% by weight based on the core particles.

The particle diameter of the conductive particles P is preferably 1 to 500 µm, more preferably 2 to 400 µm, still more preferably 5 to 300 µm, particularly preferably 10 to 150 µm.
The particle diameter distribution (Dw/Dn) of the conductive particles P is preferably 1 to 10, more preferably 1 to 7, still more preferably 1 to 5, particularly preferably 1 to 4.
Conductive particles satisfying such conditions are used, whereby the resulting elastic anisotropically conductive films 23 become easy to deform under pressure, and sufficient electrical contact is achieved among the conductive particles P in the conductive parts 24 for connection in the elastic anisotropically conductive films 23.
Conductive particles P having such an average particle diameter can be prepared by subjecting conductive particles and/or core particles to form the conductive particles to a classification treatment by means of a classifier such as an air classifier or sonic classifier. Specific conditions for the classification treatment are suitably preset according to the intended average particle diameter and particle diameter distribution of the conductive particles, the kind of the classifier, and the like.
No particular limitation is imposed on the shape of the conductive particles P. However, they are preferably in the shape of a sphere or star, or a mass of secondary particles obtained by agglomerating these particles from the viewpoint of permitting easy dispersion of these particles in the polymeric substance-forming material.

The water content in the conductive particles P is preferably at most 5%, more preferably at most 3%, still more preferably at most 2%, particularly preferably at most 1%. The use of the conductive particles P satisfying such conditions can prevent or inhibit a molding material layer from generating bubbles when the molding material layer is subjected to a curing treatment.

Those obtained by treating surfaces of the conductive particles P with a coupling agent such as a silane coupling agent may be suitably used. By treating the surfaces of the conductive particles P with the coupling agent, the adhesion property of the conductive particles P to the elastic polymeric substance is improved, so that the resulting elastic anisotropically conductive films 23 become high in durability in repeated use.
The amount of the coupling agent used is suitably selected within limits not affecting the conductivity of the conductive particles P. However, it is preferably such an amount that a coating rate (proportion of an area coated with the coupling agent to the surface area of the conductive core particles) of the coupling agent on the surfaces of the conductive particles P amounts to at least 5%, more preferably 7 to 100%, still more preferably 10 to 100%, particularly preferably 20 to 100%.

The proportion of the conductive particles P contained in the conductive parts 24 for connection in the functional part 26 is preferably 10 to 60%, more preferably 15 to 50% in terms of volume fraction. If this proportion is lower than 10%, conductive parts 24 for connection sufficiently low in electric resistance value may not be obtained in some cases. If the proportion exceeds 60% on the other hand, the resulting conductive parts 24 for connection are liable to become brittle, so that elasticity required of the conductive parts 24 for connection may not be achieved in some cases.

In the polymeric substance-forming material, as needed, may be contained a general inorganic filler such as silica powder, colloidal silica, aerogel silica or alumina. By containing such an inorganic filler, the thixotropic property of the resulting molding material is secured, the viscosity thereof becomes high, the dispersion stability of the conductive particles P is improved, and moreover the strength of the elastic anisotropically conductive films 23 obtained by a curing treatment becomes high.
No particular limitation is imposed on the amount of such an inorganic filler used. However, the use in a too large amount is not preferred because the movement of the conductive particles P by a magnetic field is greatly inhibited in a production process, which will be described subsequently.

Such an anisotropically conductive connector 20 can be produced in accordance with the process described in, for example, Japanese Patent Application Laid-Open No. 2002-334732.

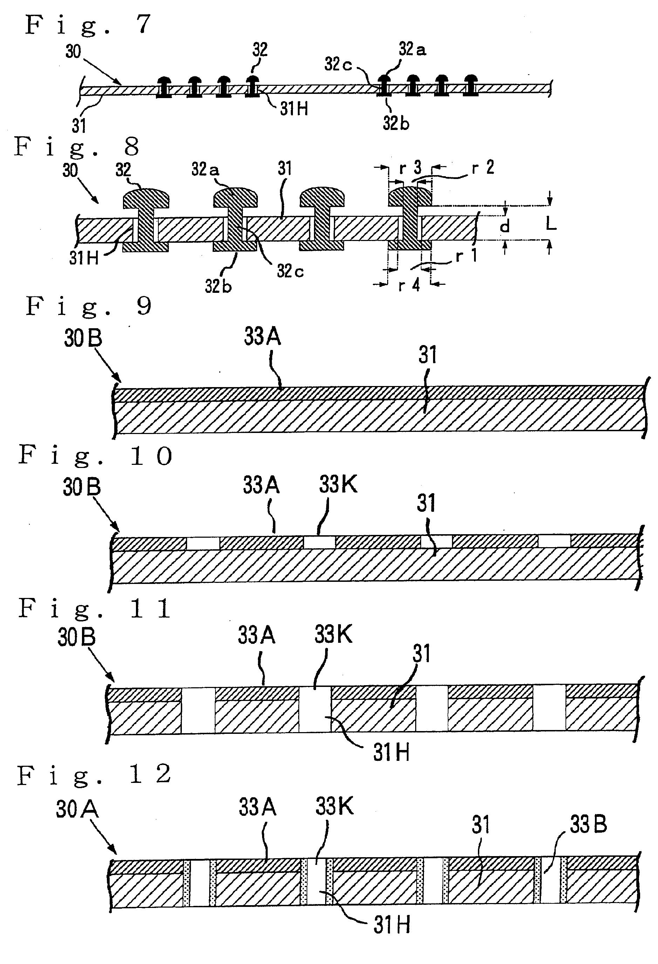

FIG. 7 is a cross-sectional view illustrating the construction of a sheet-like probe 30 in the first exemplary probe card 10, and FIG. 8 is a cross-sectional view illustrating, on an enlarged scale, the construction of a principal part of the sheet-like probe 30.
This sheet-like probe 30 has an insulating sheet 31, in which a plurality of through-holes 31H each extending in a thickness-wise direction of the insulating sheet have been formed in accordance with a pattern corresponding to a pattern electrode to be inspected in integrated circuits formed on a wafer, which is an object of inspection. Each of the through-holes 31H in the insulating sheet 31 in this embodiment has a uniform diameter. Accordingly, the front surface-side opening diameter and back surface-side opening diameter of the through-hole 31H are substantially equal to each other. Electrode structures 32 are arranged in the respective through-holes 31H in the insulating sheet 31 so as to protrude from both surfaces of the insulating sheet 31. On a back surface of the insulating sheet 31, a circular ring-like holding member 40 is arranged along a peripheral edge portion of the insulating sheet 31 (see FIG. 1), and the insulating sheet 31 is held by the holding member 40.
Each of the electrode structures 32 is constructed by integrally connecting a projected front-surface electrode part 32a exposed to a front surface of the insulating sheet 31 and a flat plate-like back-surface electrode part 32b exposed to a back surface of the insulating sheet 31 to a columnar short circuit part 32c inserted through into the through-hole 31H in the insulating sheet 31. The short circuit part 32a in the electrode structure 32 of this embodiment has a uniform diameter. The length L of the short circuit part 32a in the electrode structure 32 is greater than the thickness d of the insulating sheet 31, and the diameter r2 of the short circuit part 32a is smaller than the diameter r1 of the through-hole 31H in the insulating sheet 31, whereby the electrode structure 32 is movable in the thickness-wise direction of the insulating sheet 31. The diameter r3 of the front-surface electrode part 32a and the diameter r4 of the back-surface electrode part 32b in the electrode structure 32 are each greater than the diameter r1 of the through-hole 31H in the insulating sheet 31.

As a material for forming the insulating sheet 31, may be used a resin material such as a liquid crystal polymer, polyimide resin, polyester resin, polyaramide resin or polyamide resin, a fiber-reinforced resin material such as a glass fiber-reinforced epoxy resin, glass fiber-reinforced polyester resin or glass fiber-reinforced polyimide resin, or a composite resin material with an inorganic material such as alumina or boron nitride contained as a filler in an epoxy resin or the like.
As the insulating sheet 31, is preferably used that having a coefficient of linear thermal expansion of at most 3 x 10⁻⁵/K, more preferably 1 x 10⁻⁶ to 2 x 10⁻⁵/K, particularly preferably 1 x 10⁻⁶ to 6 x 10⁻⁶/K. Such an insulating sheet 31 is used, whereby positional deviation of the electrode structures 32 due to the thermal expansion of the insulating sheet 31 can be inhibited.
The thickness d of the insulating sheet 31 is preferably 10 to 200 µm, more preferably 15 to 100 µm.
The diameter r1 of each of the through-holes 31H in the insulating sheet 31 is preferably 20 to 250 µm, more preferably 30 to 150 µm.

As a material for forming the electrode structures 32, may be suitably used a metallic material. In particular, a material harder to be etched than a thin metal layer formed on the insulating sheet in a production process, which will be described subsequently, is preferably used. As specific examples of such a metallic material, may be mentioned simple metals such as nickel, cobalt, gold and aluminum, and alloys of these metals. The electrode structures 32 may also be those obtained by laminating at least two metals.
When electrical inspection is conducted on electrodes to be inspected, on the surfaces of which an oxide film has been formed, it is necessary to bring each of the electrode structures 32 in the sheet-like probe 30 into contact with its corresponding electrode to be inspected to break the oxide film on the surface of the electrode to be inspected by the front-surface electrode part 32a of the electrode structure 32, thereby achieving electrical connection between the electrode structure 32 and the electrode to be inspected. Therefore, the front-surface electrode part 32a of the electrode structure 32 preferably has such hardness that the oxide film can be easily broken. In order to obtain such front-surface electrode parts 32a, a powdery material having high hardness may be contained in a metal forming the front-surface electrode parts 32a.
As such a powdery material, may be used diamond powder, silicon nitride, silicon carbide, ceramic, glass or the like. A proper amount of such a nonconductive powdery material is contained, whereby the oxide film formed on the surface of the electrode to be inspected can be broken by the front-surface electrode part 32a of the electrode structure 32 without impairing the conductivity of the electrode structure 32.
In order to easily break the oxide film on the surface of the electrode to be inspected, the front-surface electrode part 32a in the electrode structure 32 may be shaped into a sharply projected form, or fine irregularities may be formed at the surface of the front-surface electrode part 32a.
A coating film may be formed on the front-surface electrode part 32a and back-surface electrode part 32b in each of the electrode structures 32 as needed. When the electrodes to be inspected are formed of, for example, a solder material, a coating film composed of a diffusion-resistant metal such as silver, palladium or rhodium is preferably formed on the front-surface electrode part 32a from the viewpoint of preventing diffusion of the solder material.

The diameter r2 of the short circuit part 32c in each of the electrode structures 32 is preferably at least 18 µm, more preferably at least 25 µm. If this diameter r2 is too small, necessary strength may not be achieved on such electrode structures 32 in some cases. A difference (r1 - r2) between the diameter r1 of the through-hole 31H in the insulating sheet 31 and the diameter r2 of the short circuit part 32c in the electrode structure 32 is preferably at least 0.5 µm, more preferably at least 1 µm, still more preferably at least 2 µm. If this difference is too small, it may be difficult in some cases to move the electrode structure 32 in the thickness-wise direction of the insulating sheet 31.
The diameter r3 of each of the front-surface electrode parts 32a in the electrode structures 32 is preferably 70 to 150% of a diameter of an electrode to be inspected. A difference (r3 - r1) between the diameter r3 of the front-surface electrode part 32a in the electrode structure 32 and the diameter r1 of the through-hole 31H in the insulating sheet 31 is preferably at least 3 µm, more preferably at least 5 µm, still more preferably at least 10 µm. If this difference is too small, the electrode structures 32 may possibly fall off from the insulating sheet 31.
The diameter r4 of each of the back-surface electrode parts 32b in the electrode structures 32 is preferably 70 to 150% of the diameter of each of the inspection electrodes 16 of the circuit board 11 for inspection. A difference (r4 - r1) between the diameter r4 of the back-surface electrode part 32b in the electrode structure 32 and the diameter r1 of the through-hole 31H in the insulating sheet 31 is preferably at least 3 µm, more preferably at least 5 µm, still more preferably at least 10 µm. If this difference is too small, the electrode structures 32 may possibly fall off from the insulating sheet 31.
A movable distance of each of the electrode structures 32 in the thickness-wise direction of the insulating sheet 31, i.e., a difference (L - d) between the length L of the short circuit part 32c in the electrode structure 32 and the thickness d of the insulating sheet is preferably 5 to 50 µm, more preferably 10 to 40 µm. If the movable distance of the electrode structure 32 is too small, it may be difficult in some cases to achieve good electrical connection. If the movable distance of the electrode structure 32 is too great on the other hand, the length of the short circuit part 32c of the electrode structure 32, which is exposed from the through-hole 31H in the insulating sheet 31 becomes great, so that the short circuit part 32c of the electrode structure 32 may possibly be buckled or damaged when the sheet-like probe is used in inspection.

A pitch p between the electrode structures 32 is preset according to a pitch between electrodes to be inspected of a wafer, which is an object of inspection, and is, for example, preferably 40 to 250 µm, more preferably 40 to 150 µm.
The term "pitch between the electrode structures" as used herein means the shortest center distance between adjoining electrode structures.

As a material for forming the holding member 14, may be used an invar alloy such as invar or superinvar, an Elinvar alloy such as Elinvar, a low-thermal expansion metal material such as covar or 42 alloy, or a ceramic material such as alumina, silicon carbide or silicon nitride.

In the sheet-like probe 30, the back-surface electrode part 32b in each of the electrode structures 32 is arranged so as to come into contact with its corresponding conductive part 24 for connection in the elastic anisotropically conductive film 23 of the anisotropically conductive connector 20, and the holding member 40 is interlocked with and fixed to the step portion 14S of the holder 14.

Such a sheet-like probe 30 can be produced, for example, in the following manner.
A laminate material 30B obtained by integrally laminating an easily etchable metal layer 33A on one surface of an insulating sheet 31 is first provided as illustrated in FIG. 9, and the metal layer 33A in the laminate material 30B is subjected to an etching treatment to remove a part thereof, thereby forming a plurality of openings 33K in the metal layer 33A in accordance with a pattern corresponding to a pattern of electrodes to be connected as illustrated in FIG. 10. Through-holes 31H respectively linking to the openings 33K of the metal layer 33A and each extending in a thickness-wise direction of the insulating sheet are then formed in the insulating sheet 31 in the laminate material 30B as illustrated in FIG. 11. Easily etchable cylindrical thin metal layers 33B are then formed so as to cover the inner wall surfaces of the through-holes 31H in the insulating sheet 31 and the opening edges of the metal layer 33A as illustrated in FIG. 12. In such a manner, a composite laminate material 30A having the insulating sheet 31, in which a plurality of the through-holes 31H each extending in the thickness-wise direction have been formed, the easily etchable metal layer 33A laminated on one surface of the insulating sheet 31 and having a plurality of the openings 33K respectively linking to the through-holes 31H in this insulating sheet 31, and the easily etchable thin metal layers 33B each formed so as to cover the inner wall surface of the through-hole 31H in the insulating sheet 31 and the opening edge of the metal layer 33A is produced.
In the above-described production process, as a method for forming the through-holes 31H in the insulating sheet 31, may be used a laser beam machining method, drill machining method, etching method or the like.
As an easily etchable metallic material for forming the metal layer 33A and the thin metal layers 33B, may be used copper or the like.
The thickness of the metal layer 33A is preset in view of the intended movable distance of each of the electrode structures 32, or the like. Specifically, the thickness is preferably 5 to 25 µm, more preferably 8 to 20 µm.
The thickness of the thin metal layers 33B is preset in view of the diameter of the through-holes 31H in the insulating sheet 31 and the diameter of the short circuit parts 32c in electrode structures 32 to be formed.
As a method for forming the thin metal layers 33B, may be used an electroless plating method or the like.

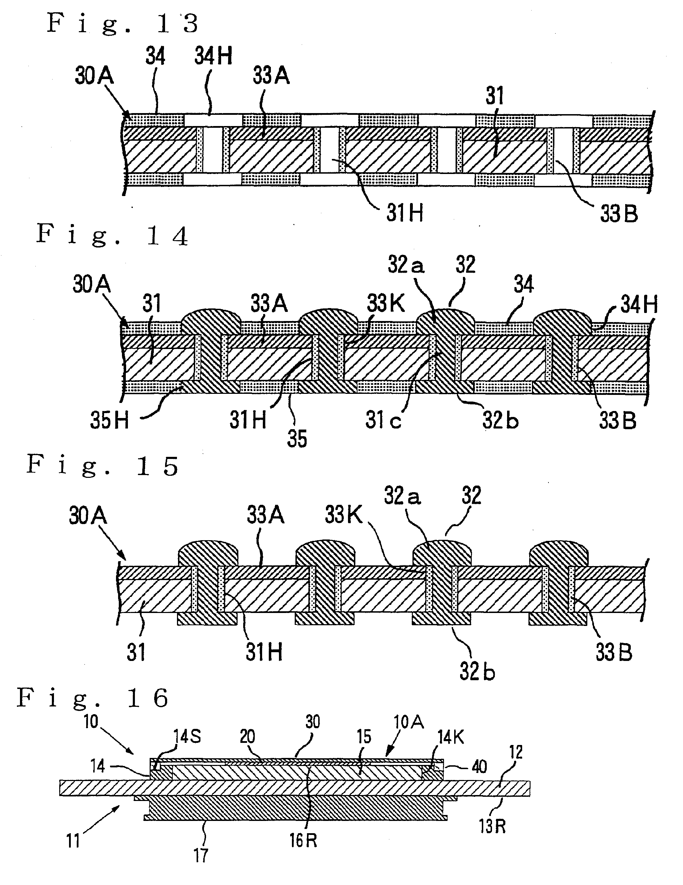

This composite laminate material 30A is subjected to a photo-plating treatment, thereby forming the electrode structures 32 in the respective through-holes 31H in the insulating sheet 31. Specifically, as illustrated in FIG. 13, a resist film 34, in which a plurality of pattern holes 34H respectively linking to the through-holes 31H in the insulating sheet 31 have been formed in accordance with a pattern corresponding to a pattern of front-surface electrode parts 32a in electrode structures 32 to be formed, is formed on the surface of the metal layer 33A, and a resist film 35, in which a plurality of pattern holes 35H respectively linking to the through-holes 31H in the insulating sheet 31 have been formed in accordance with a pattern corresponding to a pattern of back-surface electrode parts 32b in the electrode structures 32 to be formed, is formed on the back surface of the insulating sheet 31. An electroplating treatment is then conducted by using the metal layer 33A as a common electrode to deposit a metal on exposed portions in the metal layer 33A and at the same time to deposit a metal on the surfaces of the thin metal layers 33B, thereby forming metal bodies into the through-holes 31H in the insulating sheet 31 and the pattern holes 34H and 35H in the resist films 34 and 35. One end surfaces of the metal bodies, which are exposed from the pattern holes 35H in the resist film 35, are polished, thereby forming the electrode structures 32 each extending in the thickness-wise direction of the insulating sheet 31 as illustrated in FIG. 14.
After the electrode structures 32 are formed in such a manner, the resist film 34 is removed from the surface of the metal layer 33A, and the resist film 35 is removed from the back surface of the insulating sheet 31, thereby exposing the metal layer 33A and the insulating sheet 31 as illustrated in FIG. 15. An etching treatment is then conducted to remove the metal layer 33A and the thin metal layers 33B, thereby obtaining the sheet-like probe 30 illustrated in FIG. 7.

According to such first exemplary probe card 10, each of the electrode structures 32 in the sheet-like probe 30 is provided movably in the thickness-wise direction of the insulating sheet 31, so that even when a scatter occurs on the projected height of the front-surface electrode parts 32a in the electrode structures 32, each of the electrode structures 32 moves in the thickness-wise direction of the insulating sheet 31 according to the projected height of the front-surface electrode part 32a thereof when the electrodes to be inspected are pressurized. Accordingly, a good electrically connected state to the wafer can be surely achieved.
In addition, the front-surface electrode parts 32a and back-surface electrode parts 32b each have a diameter greater than the diameter of the through-hole 31H in the insulating sheet 31, so that the front-surface electrode parts 32a and back-surface electrode parts 32b each function as a stopper. As a result, the electrode structures 32 can be prevented from falling off from the insulating sheet 31.
Further, that having a low coefficient of linear thermal expansion is used as a material forming the insulating sheet 31, whereby positional deviation between the electrode structures 32 and the electrodes to be inspected due to thermal expansion of the insulating sheet 31 can be inhibited.
In addition, in the anisotropically conductive connector 20, the elastic anisotropically conductive films 23 are respectively arranged in a plurality of the openings 22 formed in the frame plate 21 and supported by the frame plate 21, whereby each of the elastic anisotropically conductive films 23 may be small in area. Since the elastic anisotropically conductive film 23 small in area is little in the absolute quantity of thermal expansion in a plane direction thereof, positional deviation of the conductive parts 24 for connection to the inspection electrodes 12 and electrode structures 32 by temperature change can be inhibited.
Accordingly, the good electrically connected state to the wafer can be stably retained in the burn-in test on the wafer.

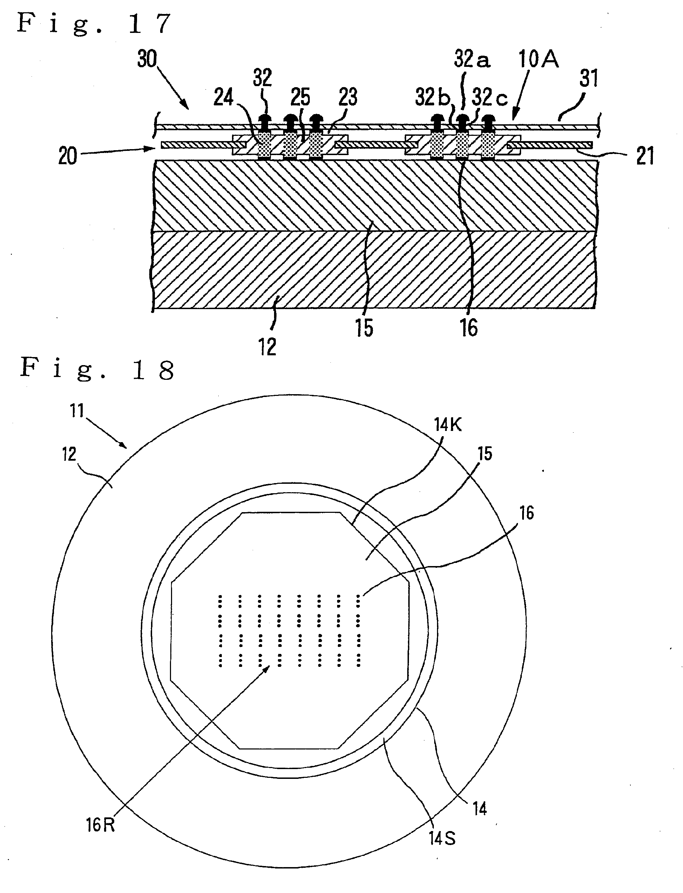

FIG. 16 is a cross-sectional view illustrating the construction of a second exemplary probe card according to the present invention, and FIG. 17 is a cross-sectional view illustrating the construction of a principal part of the second exemplary probe card.
This second exemplary probe card 10 is used for collectively conducting a probe test on, for example, a wafer, on which a plurality of integrated circuits have been formed, as to each of the integrated circuits in a state of the wafer, and is constructed by a circuit board 11 for inspection and a probe member 10A arranged on one surface (upper surface in FIG. 16 and FIG. 17) of this circuit board 11 for inspection, and the probe member 10A is constructed by a sheet-like probe 30 and an anisotropically conductive connector 20 arranged on a back surface of this sheet-like probe 30.
In the circuit board 11 for inspection of the second exemplary probe card 10, as illustrated in FIG. 18, an inspection electrode part 16R, in which a plurality of inspection electrodes 16 are arranged in accordance with a pattern corresponding to a pattern of electrodes to be inspected in, for example, 32 (8 x 4) integrated circuits among integrated circuits formed on a wafer, which is an object of inspection, is formed on a front surface of a second base element 15. Other constructions in the circuit board 11 for inspection are fundamentally the same as those in the circuit board 11 for inspection in the first exemplary probe card 10.

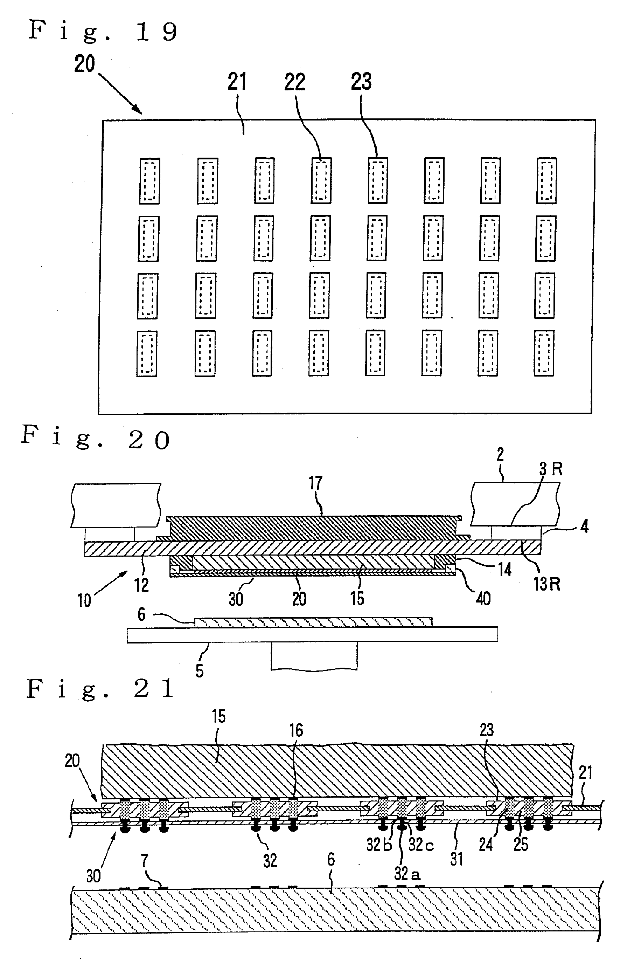

The anisotropically conductive connector 20 in the probe member 10A has a rectangular plate-like frame plate 21, in which a plurality of openings 22 each extending through in a thickness-wise direction of the frame plate have been formed, as illustrated in FIG. 19. The openings 22 in this frame plate 21 are formed corresponding to a pattern of electrode regions, in which electrodes to be inspected in, for example, 32 (8 x 4) integrated circuits among integrated circuits formed on the wafer, which is the object of inspection, have been formed. In the frame plate 21, a plurality of elastic anisotropically conductive films 23 having conductivity in a thickness-wise direction thereof are arranged in a state supported by their corresponding opening edges of the frame plate 21 so as to close the respective openings 22. Other constructions in the anisotropically conductive connector 20 are the same as those in the anisotropically conductive connector 20 of the first exemplary probe card 10.

The sheet-like probe 30 has an insulating sheet 31, in which a plurality of through-holes 31H each extending in a thickness-wise direction of the insulating sheet have been formed in accordance with a pattern corresponding to a pattern of electrodes to be inspected in, for example, 32 (8 x 4) integrated circuits among integrated circuits formed on the wafer, which is the object of inspection. Electrode structures 32 are arranged in the respective through-holes 31H in the insulating sheet 31 so as to protrude from both surfaces of the insulating sheet 31. On a back surface of the insulating sheet 31, a circular ring-like holding member 40 is arranged along a peripheral edge portion of the insulating sheet 31, and the insulating sheet 31 is held by the holding member 40. Other constructions in this sheet-like probe 30 are the same as those in the sheet-like probe 30 of the first exemplary probe card 10.
The sheet-like probe 30 of this embodiment can be produced in the same manner as in the sheet-like probe 30 of the first exemplary probe card 10.
In the sheet-like probe 30, the back-surface electrode part 32b in each of the electrode structures 32 is arranged so as to come into contact with its corresponding conductive part 24 for connection in the elastic anisotropically conductive film 23 of the anisotropically conductive connector 20, and the holding member 40 is interlocked with and fixed to a step portion 14S of a holder 14.

According to such second exemplary probe card 10, each of the electrode structures 32 in the sheet-like probe 30 is provided movably in the thickness-wise direction of the insulating sheet 31, so that even when a scatter occurs on the projected height of the front-surface electrode parts 32a in the electrode structures 32, each of the electrode structures 32 moves in the thickness-wise direction of the insulating sheet 31 according to the projected height of the front-surface electrode part 32a thereof when the electrodes to be inspected are pressurized. Accordingly, a good electrically connected state to the wafer can be surely achieved.
In addition, the front-surface electrode parts 32a and back-surface electrode parts 32b each have a diameter greater than the diameter of the through-hole 31H in the insulating sheet 31, so that the front-surface electrode parts 32a and back-surface electrode parts 32b each function as a stopper. As a result, the electrode structures 32 can be prevented from falling off from the insulating sheet 31.
Further, that having a low coefficient of linear thermal expansion is used as a material forming the insulating sheet 31, whereby positional deviation between the electrode structures 32 and the electrodes to be inspected due to thermal expansion of the insulating sheet 31 can be inhibited.
Accordingly, the good electrically connected state to the wafer can be stably retained in the probe test on the wafer.

### [Wafer inspection apparatus]

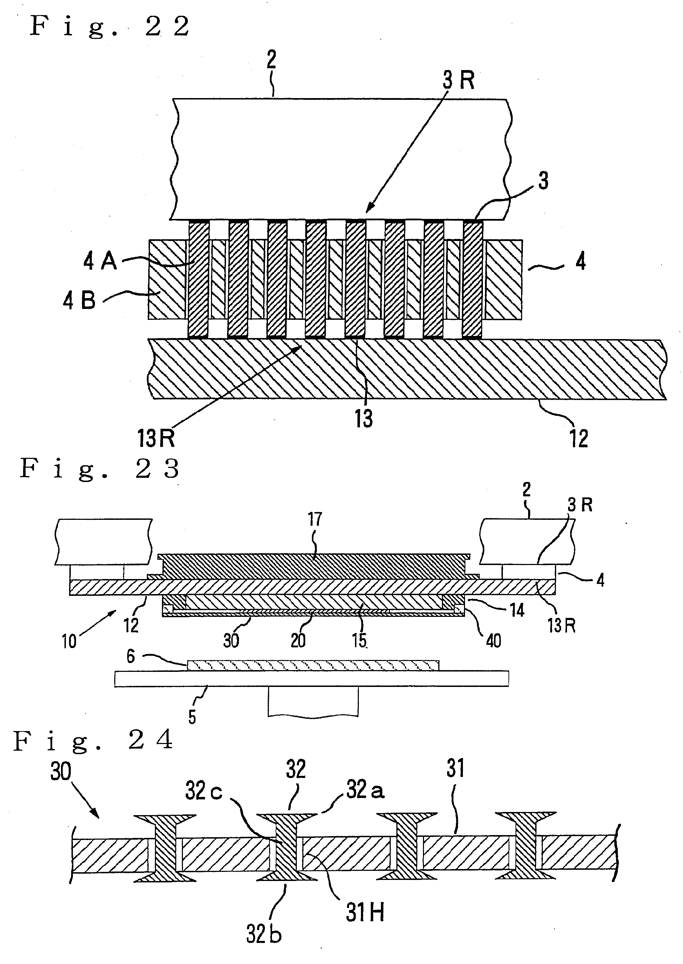

FIG. 20 is a cross-sectional view schematically illustrating the construction of a first exemplary wafer inspection apparatus according to the present invention, and FIG. 21 is a cross-sectional view illustrating, on an enlarged scale, a principal part of the first exemplary wafer inspection apparatus. This first exemplary wafer inspection apparatus serves to collectively perform a burn-in test on each of a plurality of integrated circuits formed on a wafer in a state of the wafer.
The first exemplary wafer inspection apparatus has a controller 2 serving to make temperature control of a wafer 6, which is an object of inspection, supply an electric power for conducting the inspection of the wafer 6, make input-output control of signals and detect output signals from the wafer 6 to judge the quality of integrated circuits on the wafer 6. As illustrated in FIG. 22, the controller 2 has, on a lower surface thereof, an input-output terminal part 3R, in which a great number of input-output terminals 3 are arranged along a circumferential direction thereof.
The first exemplary probe card 10 is arranged below the controller 2 in a state held by a proper holding means in such a manner that each of the lead electrodes 13 formed on the first base element 12 in the circuit board 11 for inspection is opposed to its corresponding input-output terminal 3 of the controller 2 as illustrated in FIG. 22.
A connector 4 is arranged between the input-output terminal part 3R of the controller 2 and the lead electrode part 13R of the circuit board 11 for inspection in the probe card 10, and each of the lead electrodes 13 formed on the first base element 12 is electrically connected to its corresponding input-output terminal 3 of the controller 2 through the connector 4. The connector 4 in the illustrated embodiment is constructed by a plurality of conductive pins 4A capable of being elastically compressed in a lengthwise direction thereof and a supporting member 4B supporting these conductive pins 4A, and each of the conductive pins 4A is arranged so as to be located between the input-output terminal 3 of the controller 2 and the lead electrode 13 formed on the first base element 12.
A wafer mounting table 5, on which the wafer 6 that is the object of inspection is mounted, is provided below the probe card 10.

In such a wafer inspection apparatus, the wafer 6, which is the object of inspection, is mounted on the wafer mounting table 5, and the probe card 10 is then pressurized downward, whereby the respective front-surface electrode parts 32a in the electrode structures 32 of the sheet-like probe 30 thereof are brought into contact with their corresponding electrodes 7 to be inspected of the wafer 6, and moreover the respective electrodes 7 to be inspected of the wafer 6 are pressurized by the respective front-surface electrodes parts 32a. In this state, each of the conductive parts 24 for connection in the elastic anisotropically conductive films 23 of the anisotropically conductive connector 20 is pinched by the inspection electrode 16 of the circuit board 11 for inspection and the back-surface electrode part 32b of the electrode structure 32 in the sheet-like probe 30 and compressed in the thickness-wise direction, whereby conductive paths are formed in the respective conductive parts 24 for connection in the thickness-wise direction thereof. As a result, electrical connection between the electrodes 7 to be inspected of the wafer 6 and the inspection electrodes 16 of the circuit board 11 for inspection is achieved. Thereafter, the wafer 6 is heated to a predetermined temperature through the wafer mounting table 6. In this state, necessary electrical inspection is performed on each of plural integrated circuits in the wafer 6.

According to such a first exemplary wafer inspection apparatus, electrical connection to the electrodes 7 to be inspected of the wafer 6, which is the object of inspection, is achieved through the first exemplary probe card 10, so that a good electrically connected state to the wafer can be surely achieved, and moreover the good electrically connected state to the wafer can be stably retained. Accordingly, in the burn-in test on the wafer, necessary electrical inspection on the wafer can be surely performed.

FIG. 23 is a cross-sectional view schematically illustrating the construction of a second exemplary wafer inspection apparatus according to the present invention. This wafer inspection apparatus serves to perform a probe test on each of a plurality of integrated circuits formed on a wafer in a state of the wafer.
This second exemplary wafer inspection apparatus has fundamentally the same construction as in the first exemplary wafer inspection apparatus except that the second exemplary probe card 10 is used in place of the first exemplary probe card 10.
In the second exemplary wafer inspection apparatus, the probe card 10 is electrically connected to electrodes 7 to be inspected in, for example, 32 integrated circuits selected from among all integrated circuits formed on the wafer 6 to conduct inspection. Thereafter, the probe card 10 is electrically connected to electrodes 7 to be inspected of a plurality of integrated circuits selected from among other integrated circuits to conduct inspection. These processes are repeated, whereby the probe test on all the integrated circuits formed on the wafer 6 is conducted.
According to such a second exemplary wafer inspection apparatus, electrical connection to the electrodes 7 to be inspected of the wafer 6, which is the object of inspection, is achieved through the second exemplary probe card 10, so that a good electrically connected state to the wafer can be surely achieved, and moreover the good electrically connected state to the wafer can be stably retained. Accordingly, in the probe test on the wafer, necessary electrical inspection on the wafer can be surely performed.

The present invention is not limited to the embodiments described above, and various changes or modifications can be added thereto as described below.
(1) It is not essential to form the projected parts on the anisotropically conductive films 23 in the anisotropically conductive connector 20, and the surface of each of the anisotropically conductive films 23 may be flat.
(2) In addition to the conductive parts 24 for connection formed in accordance with the pattern corresponding to the pattern of the electrodes to be inspected, conductive parts for non-connection that are not electrically connected to any electrode to be inspected may be formed in the anisotropically conductive films 23 in the anisotropically conductive connector 20.
(3) The sheet-like probe 30 may have a construction having an insulating sheet, in which a single opening has been formed, and an insulating film arranged so as to close the opening in the insulating sheet, a construction having an insulating sheet, in which a plurality of openings have been formed, and a plurality of insulating films arranged so as to close the respective openings, or a construction having an insulating sheet, in which a plurality of openings have been formed, one or more insulating films arranged so as to close one opening in the insulating sheet and one or more insulating films so as to close two or more openings in the insulating sheet.
(4) In the sheet-like probe 30, the front-surface electrode part 32a and back-surface electrode part 32b in each of the electrode structures 32 may have a substantially truncated cone shape as illustrated in FIG. 24, and the diameter of an end surface in each of the front- and back-surface electrode parts may be greater than the front surface-side opening diameter and back surface-side opening diameter of the through-hole 31H in the insulating sheet 31.
   Such a sheet-like probe 30 can be produced in the following manner.

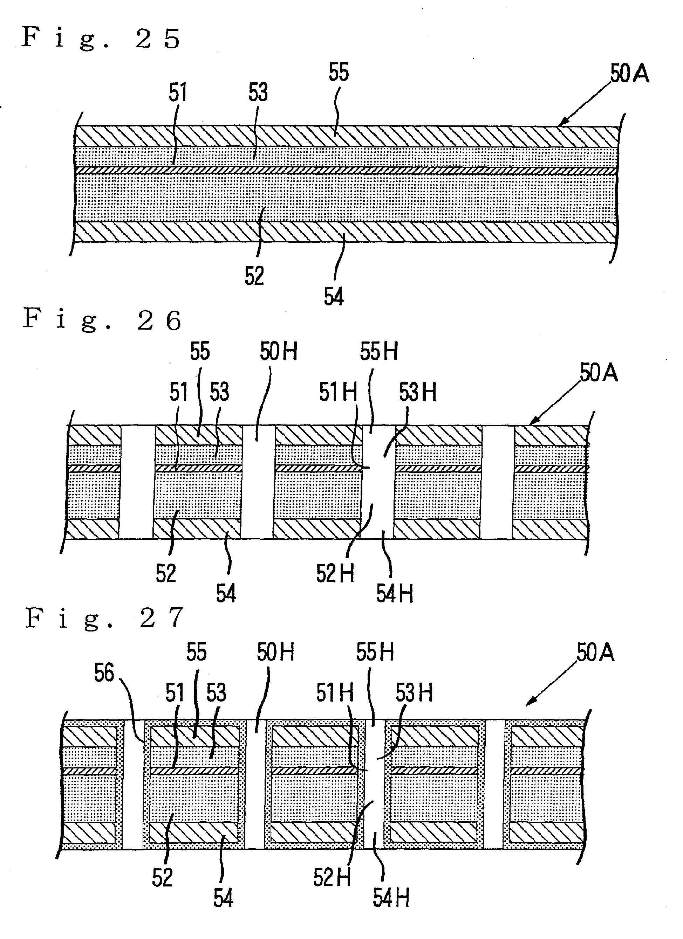

As illustrated in Fig. 25, a laminate material 50A having an easily etchable metal foil 51 and resist layers 52, 53 integrally laminated on one surface (lower surface in the drawing) and the other surface of this metal foil 51, respectively, is first produced. The total thickness of the metal foil 51 and the resist layers 52, 53 in this laminate material 50A is designed to be greater than the length of each of the electrode structures 32 to be formed, and the resist layer (hereinafter also referred to as "one resist layer") 52 formed on one surface of the metal foil 51 is designed to have a thickness greater than the thickness of the insulating sheet in the intended sheet-like probe. In the laminate material 50A of the illustrated embodiment, resin sheets 54, 55 each composed of, for example, a polyvinyl chloride are laminated on the surfaces of the resist layer 52, 53, respectively.
In such a laminate material 50A, copper or the like may be used as an easily etchable metallic material for forming the metal foil 51.
The thickness of the metal foil 51 is preferably 3 to 75 µm, more preferably 5 to 50 µm, still more preferably 8 to 25 µm.
The thickness of said one resist layer 52 is suitably selected according to the thickness of the insulating sheet in the intended sheet-like probe. However, it is, for example, 10 to 200 µm, preferably 15 to 100 µm.
The thickness of the resist layer (hereinafter also referred to as "the other resist layer") 53 formed on the other surface of the metal foil 51 is, for example, 10 to 50 µm, preferably 15 to 30 µm.
The resin sheets 54, 55 each have a thickness of 10 to 100 µm.

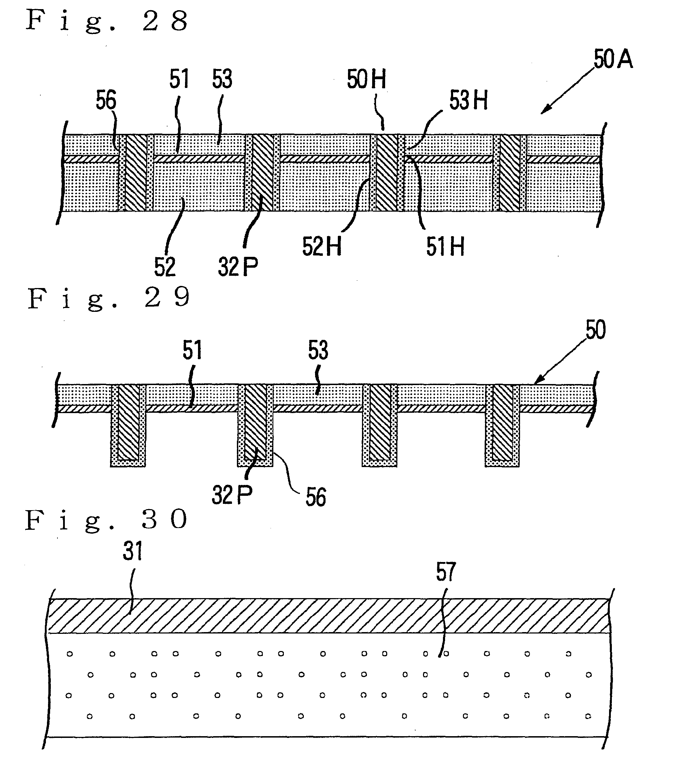

Such a laminate material 50A is subjected to laser beam machining, whereby through-holes 51H, 52H, 53H, 54H and 55H linking to one another are formed in the metal foil 51, the resist layers 52, 53 and the resin sheets 54, 55, respectively, in accordance with a pattern corresponding to a pattern of electrodes to be inspected of a wafer, which is an object of inspection, as illustrated in FIG. 26, thus forming through-holes 50H extending through in a thickness-wise direction of the laminate material 50A.
The laminate material 50A is then subjected to an electroless plating treatment, whereby easily etchable thin metal layers 56 are formed so as to cover the inner wall surfaces of the through-holes 50H in the laminate material 50A, i.e., the inner wall surfaces of the through-holes 51H in the metal foil 51, the inner wall surfaces of the through-holes 52H, 53H in the resist layers 52, 53, and the surfaces of the resin sheets 54, 55 and the inner wall surfaces of the through-holes 54H, 55H therein as illustrated in FIG. 27. Thereafter, the resin sheets 54, 55 are separated from the resist layers 52, 53, respectively. The laminate material 50A is then subjected to an electroplating treatment using the metal foil 51 and the thin metal layers 56 as an electrode, whereby a metal is deposited in the through-holes 51H in the metal foil 51 and the through-holes 52H, 53H in the resist layers 52, 53. As a result, columnar posts 32P for electrode structure are formed as illustrated in FIG. 28. The surfaces of the resist layers 52, 53 and the both end surfaces of each of the posts 32P for electrode structure are then subjected to a polishing treatment, and thereafter said one resist layer 52 is separated from one surface of the metal foil 51, and the posts 32P for electrode structure are subjected to an electroless plating treatment, thereby creating a state that all the surfaces of portions protruding from one surface of the metal foil 51 in the posts 32P for electrode structure have been covered with the easily etchable thin metal layer 56 as illustrated in FIG. 29, thus obtaining a composite material 50.
In the above-described process, the diameter of each through-hole 50H formed in the laminate material 50A is preset according to the diameter of the short circuit part 32c in each of the electrode structures 32 to be formed.
Copper or the like may be used as an easily etchable metallic material for forming the thin metal layers 56.
The thickness of the thin metal layers 56 is preset in view of the diameter of the through-holes 50H in the laminate material 50A and the diameter of the short circuit parts 32c in the electrode structures 32 to be formed.

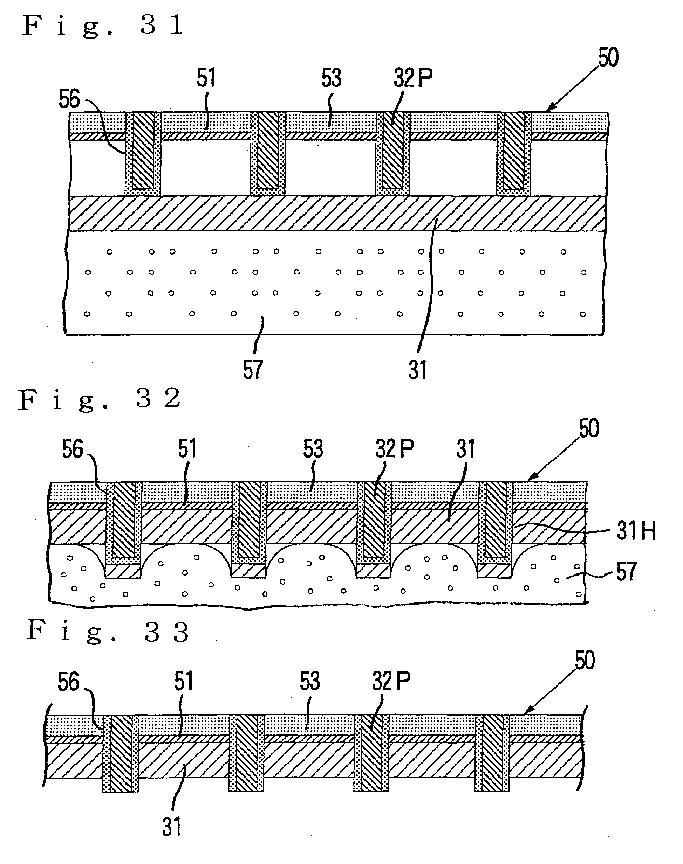

An insulating sheet 31 is arranged on a cushioning material 57 composed of a polymeric elastic substance as illustrated in FIG. 30, an adhesive layer (not illustrated) is formed on an upper surface of the insulating sheet 31, and the composite material 50 produced above is arranged on the upper surface of the insulating sheet 31, on which the adhesive layer has been formed, in such a manner that the thin metal layers 56 formed on the end surfaces of the respective posts 32P for electrode structure come into contact with the insulating sheet 31 as illustrated in FIG. 31. In this state, the insulating sheet 31 is pressed in a thickness-wise direction thereof by, for example, the composite material 50, whereby holes are formed in the insulating sheet 31 by the respective posts 32P for electrode structure, on which the thin metal layer 56 has been formed, thereby forming a plurality of through-holes 31H in the insulating sheet 31 to create a state that the posts 32P for electrode structure have been inserted through into the respective through-holes 31H as illustrated in FIG. 32. At this time, the metal foil 50 in the composite material 50 is releasably fixed to the upper surface of the insulating sheet 31 by the adhesive layer.

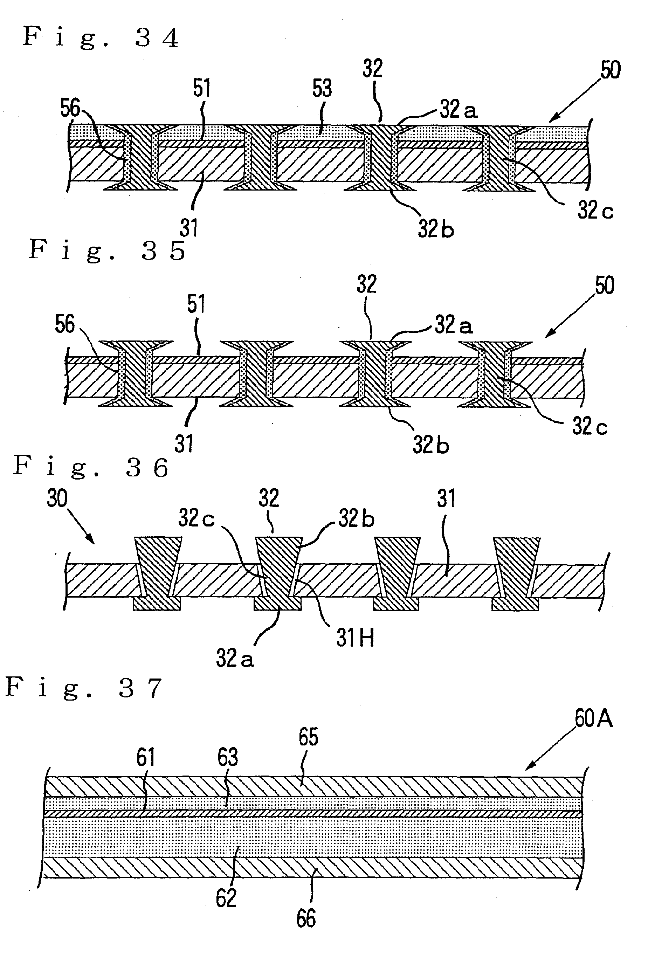

The thin metal layers 56 formed on the end surfaces of the posts 32P for electrode structure are then subjected to a polishing treatment, whereby the end surfaces of the posts 32P for electrode structure are exposed as illustrated in FIG. 33. The both ends of the posts 32P for electrode structure are then subjected to a forging treatment. Specifically, a process that the posts 32P for electrode structure are pressurized in a thickness-wise direction thereof, and the pressure is then released is repeated, thereby forming front-surface electrode parts 32a and back-surface electrode parts 32b each having an end surface greater in diameter than the front surface-side opening diameter and back surface-side opening diameter of the through-holes 31H in the insulating sheet 31 as illustrated in FIG. 34, thus forming electrode structures 32, in each of which a front-surface electrode part 32a and a back-surface electrode part 32b each having an end surface greater in diameter than the front surface-side opening diameter and back surface-side opening diameter of the through-holes 11H in the insulating sheet 31 are respectively formed continuously and integrally with both ends of a short circuit part 32c inserted through into the through-hole 31H in the insulating sheet 31.
In the above-described process, the conditions of pressurization against the posts 32P for electrode structure in the forging treatment vary according to the material and size of the posts 32P for electrode structure. However, the posts 32P for electrode structure are preferably subjected to header working by, for example, a forging machine.

After the electrode structures 32 are formed in such a manner, the resist layer 52 is separated from the metal foil 51, thereby exposing the metal foil 51 and the thin metal layers 56 as illustrated in FIG. 35. An etching treatment is then conducted to remove the metal foil 51 and the thin metal layers 56, whereby a gap is formed between the inner surface of the through-hole 31H in the insulating sheet 31 and the surface of the electrode structure 32, thereby creating a state that the electrode structures 32 is movable in the thickness-wise direction of the insulating sheet 31, thus obtaining the sheet-like probe 30 illustrated in FIG. 24.

(5) In the sheet-like probe, as illustrated in FIG. 36, the through-holes 31H in the insulating sheet 31 may be formed in a tapered form, the diameter of which becomes gradually great from the front surface (lower surface in the drawing) of the insulating sheet 31 toward the back surface thereof, and each of the electrode structures 32 may be so constructed that the electrode structure 32 is composed of a short circuit part 32c having a tapered form, the diameter of which becomes gradually great from one end on the front surface side of the insulating sheet 31 toward the other end on the back surface side thereof, a plate-like front-surface electrode part 32a formed integrally with one end of the short circuit part 32c, and a back-surface electrode part 32b formed continuously with the other end of the short circuit part 31c and having a tapered form, the diameter of which becomes gradually great toward the end surface thereof, the diameter of the front-surface electrode part 31a is greater than the front surface-side opening diameter of the through-hole 31H in the insulating sheet 31, and the diameter of the end surface of the back-surface electrode part 31b is greater than the back surface-side opening diameter of the through-hole 31H in the insulating sheet 31.
Such a sheet-like probe 30 can be produced in the following manner.

As illustrated in Fig. 37, a laminate material 60A having an easily etchable metal foil 61 and resist layers 62, 63 integrally laminated on one surface (lower surface in the drawing) and the other surface of this metal foil 61, respectively, is first produced. The total thickness of the metal foil 61 and the resist layers 62, 63 in this laminate material 60A is designed to be greater than the total length of the back-surface electrode part 32b and the short circuit part 32c in each of the electrode structures 32 to be formed, and the resist layer (hereinafter also referred to as "one resist layer") 62 formed on one surface of the metal foil 61 is designed to have a thickness greater than the thickness of the insulating sheet 31. In the laminate material 60A of the illustrated embodiment, resin sheets 64, 65 each composed of, for example, a polyvinyl chloride are laminated on the surfaces of the resist layer 62, 63, respectively.
In such a laminate material 60A, copper or the like may be used as an easily etchable metallic material for forming the metal foil 61.
The thickness of the metal foil 61 is preferably 3 to 75 µm, more preferably 5 to 50 µm, still more preferably 8 to 25 µm.
The thickness of said one resist layer 62 is suitably selected according to the thickness of the insulating sheet 31. However, it is, for example, 10 to 200 µm, preferably 15 to 100 µm.
The thickness of the resist layer (hereinafter also referred to as "the other resist layer") 63 formed on the other surface of the metal foil 61 is, for example, 10 to 50 µm, preferably 15 to 30 µm.
The resin sheets 64, 65 each have a thickness of 10 to 100 µm.

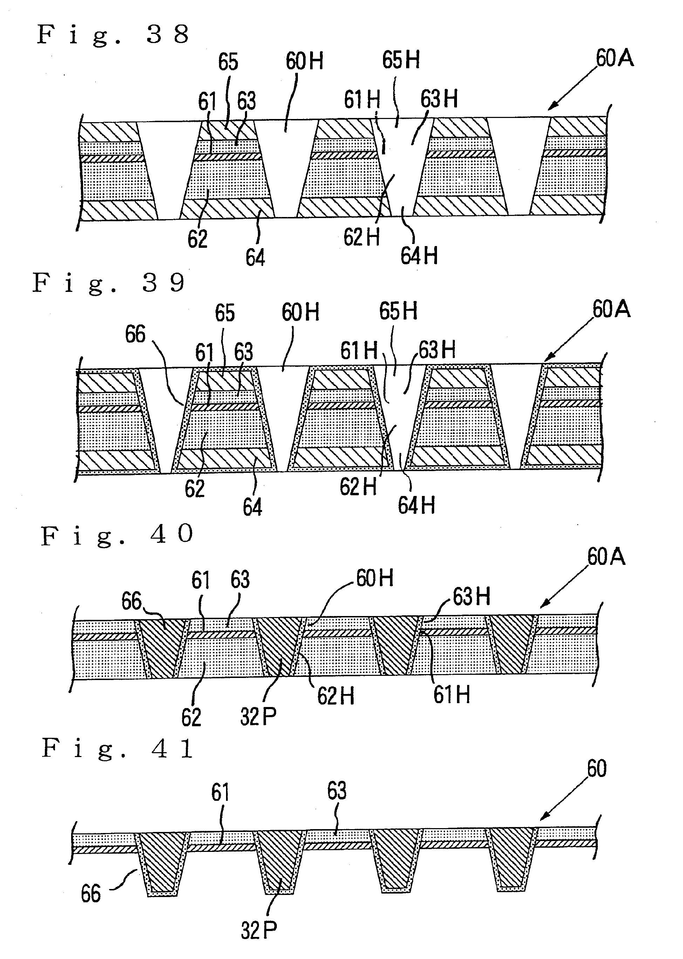

Such a laminate material 60A is subjected to laser beam machining, whereby tapered through-holes 61H, 62H, 63H, 64H and 65H linking to one another are formed in the metal foil 61, the resist layers 62, 63 and the resin sheets 64, 65, respectively, in accordance with a pattern corresponding to a pattern of electrodes to be inspected of a wafer, which is an object of inspection, as illustrated in FIG. 38, thus forming through-holes 60H extending through in a thickness-wise direction of the laminate material 60A.
The laminate material 60A is then subjected to an electroless plating treatment, whereby easily etchable thin metal layers 66 are formed so as to cover the inner wall surfaces of the through-holes 60H in the laminate material 60A, i.e., the inner wall surfaces of the through-holes 61H in the metal foil 61, the inner wall surfaces of the through-holes 62H, 63H in the resist layers 62, 63, and the surfaces of the resin sheets 64, 65 and the inner wall surfaces of the through-holes 64H, 65H therein as illustrated in FIG. 39. Thereafter, the resin sheets 64, 65 are separated from the resist layers 62, 63, respectively. The laminate material 60A is then subjected to an electroplating treatment using the metal foil 61 and the thin metal layers 66 as an electrode, whereby a metal is deposited in the through-holes 61H in the metal foil 61 and the through-holes 62H, 63H in the resist layers 62, 63. As a result, tapered posts 32P for electrode structure are formed as illustrated in FIG. 40. The surfaces of the resist layers 62, 63 and the both end surfaces of each of the posts 32P for electrode structure are then subjected to a polishing treatment, and thereafter said one resist layer 62 is separated from one surface of the metal foil 61, and the posts 32P for electrode structure are subjected to an electroless plating treatment, thereby creating a state that all the surfaces of portions protruding from one surface of the metal foil 61 in the posts 32P for electrode structure have been covered with the easily etchable thin metal layer 66 as illustrated in FIG. 41, thus obtaining a composite material 60.
In the above-described process, the diameter of each through-hole 60H formed in the laminate material 60A is preset according to the diameters of the back-surface electrode part 32b and short circuit part 32c in each of the electrode structures 32 to be formed.
Copper or the like may be used as an easily etchable metallic material for forming the thin metal layers 66.
The thickness of the thin metal layers 66 is preset in view of the diameter of the through-holes 60H in the laminate material 60A and the diameters of the back-surface electrode part 32b and short circuit part 32c in each of the electrode structures 32 to be formed.

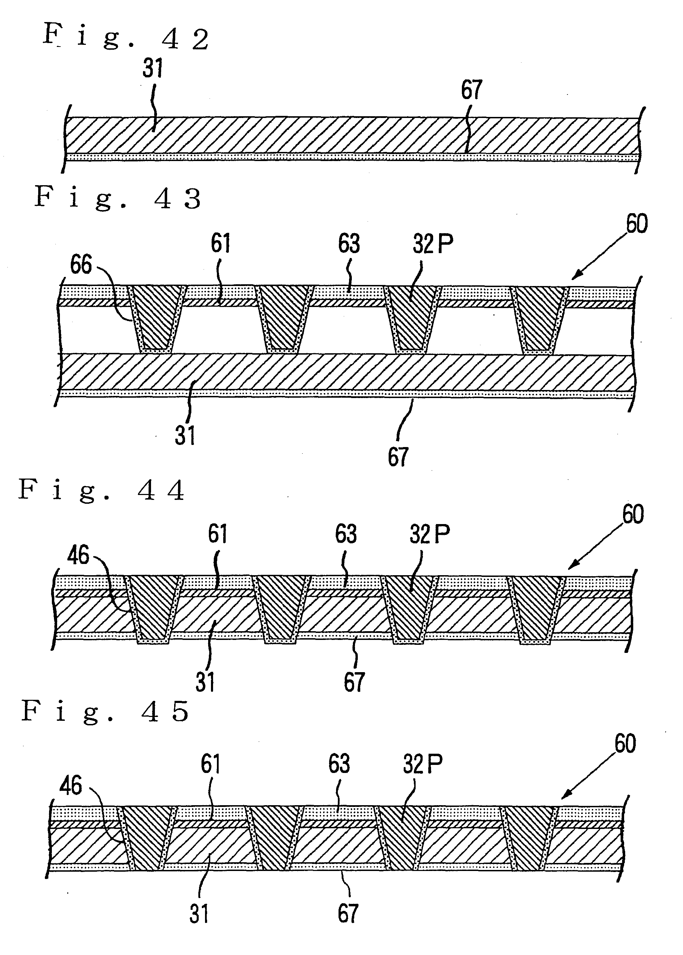

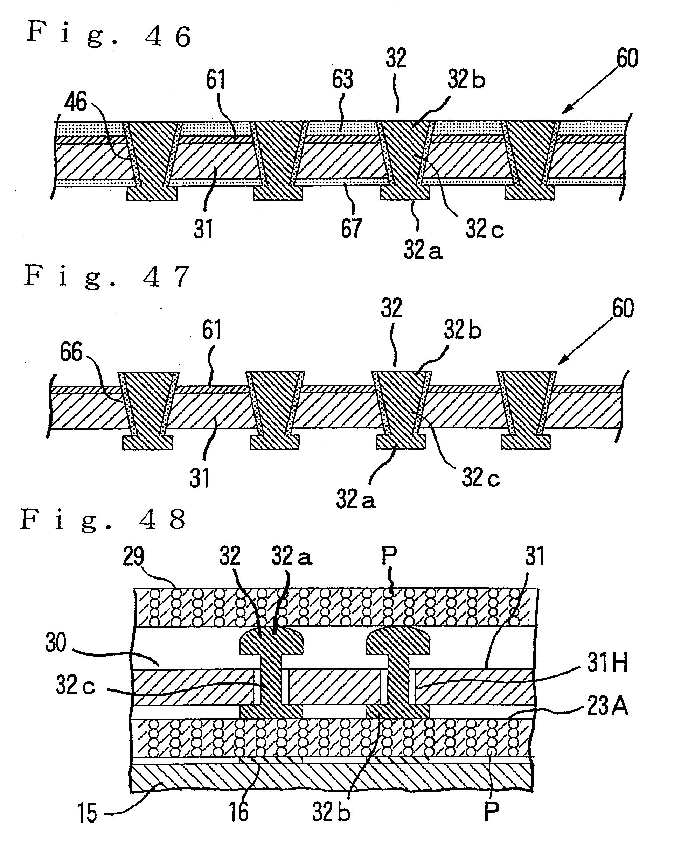

As illustrated in FIG. 42, a resist layer 67 is then formed on the front surface (lower surface in the drawing) of an insulating sheet 31, and the composite material 60 produced above is then arranged on the back surface of the insulating sheet 31 in such a manner that the thin metal layers 66 formed on the end surfaces of the respective posts 32P for electrode structure come into contact with the back surface of the insulating sheet 31 as illustrated in FIG. 43. In this state, the insulating sheet 31 is pressed in a thickness-wise direction thereof by, for example, the composite material 60, whereby holes are formed in the insulating sheet 31 and the resist layer 67 by the respective posts 32P for electrode structure, on which the thin metal layer 66 has been formed, thereby forming a plurality of through-holes 31H in the insulating sheet 31 to create a state that the posts 32P for electrode structure have been inserted through into the respective through-holes 31H as illustrated in FIG. 44. The thin metal layers 66 formed on the surface of the resist layer 67 and the surfaces of the posts 32P for electrode structure are then subjected to a polishing treatment, whereby the end surfaces of the posts 32P for electrode structure are exposed as illustrated in FIG. 45. The end surfaces of the posts 32P for electrode structure are then subjected to a plating treatment, thereby forming plate-like front-surface electrode parts 32a as illustrated in FIG. 46, thus forming electrode structures 32 each composed of the tapered short circuit part 32c, the plate-like front-surface electrode part 32a formed integrally with one end of the short circuit part 32c, and the tapered back-surface electrode part 32b formed continuously with the other end of the short circuit part 31c as illustrated in FIG. 46.
After the electrode structures 32 are formed in such a manner, the resist layers 63 and 67 are separated from the metal foil 61 and the insulating sheet 31, respectively, thereby exposing the metal foil 61 and the thin metal layers 66 as illustrated in FIG. 47. An etching treatment is then conducted to remove the metal foil 61 and the thin metal layers 66, thereby obtaining the sheet-like probe 30 illustrated in FIG. 36.

(6) In the probe cards according to the present invention, as illustrated in FIG. 48, the anisotropically conductive connector may have an elastic anisotropically conductive film 23A that conductive particles P exhibiting magnetism are contained in an elastic polymeric substance in a state oriented so as to align in a thickness-wise direction of the film to form chains and in a state that the chains by the conductive particles P have been distributed in a plane direction of the film. An anisotropically conductive elastomer sheet 29 may be arranged on the sheet-like probe 30. As such an anisotropically conductive elastomer sheet, may be used a sheet that conductive particles P exhibiting magnetism are contained in an elastic polymeric substance in a state oriented so as to align in a thickness-wise direction of the sheet to form chains and in a state that the chains by the conductive particles P have been distributed in a plane direction of the sheet.

(7) In the wafer inspection apparatus, as illustrated in FIG. 49 and FIG. 50, an anisotropically conductive connector 70 composed of a continuous filmy support 71, in which a plurality of openings 72 have been formed so as to align in a longitudinal direction of the support, and anisotropically conductive elastomer sheets 75 arranged in the respective openings 72 in the support 71, by which one anisotropically conductive elastomer sheet 75 is arranged so as to be located between the wafer 6, which is the object of inspection, and the probe card 30, and a moving mechanism 76 for moving this anisotropically conductive connector 70 in the longitudinal direction may be provided.
As a material for forming the support 71, may be used a resin material. As specific examples thereof, may be mentioned liquid polymers, polyimide resins, polyester resins, polyaramide resins and polyamide resins.
As the anisotropically conductive elastomer sheets 75, may be used those that conductive particles P exhibiting magnetism are contained in an elastic polymeric substance in a state oriented so as to align in a thickness-wise direction of the sheet to form chains and in a state that the chains by the conductive particles P have been distributed in a plane direction of the sheet.
As the moving mechanism 76, may be used that having an unwind roller 77 and a take-up roller 78.
According to the wafer inspection apparatus of such construction, when the anisotropically conductive elastomer sheet 75 in the anisotropically conductive connector 70 falls into disorder when inspection of wafers is conducted repeatedly, the anisotropically conductive connector 70 is moved by the moving mechanism 76, whereby the disordered anisotropically conductive elastomer sheet 75 can be exchanged for another anisotropically conductive elastomer sheet 75 in the anisotropically conductive connector 70 with ease and in a short period of time, so that inspection efficiency on wafers can be improved.

(8) The connector 4 for electrically connecting the controller 2 to the circuit board 11 for inspection in the wafer inspection apparatus is not limited to that illustrated in FIG. 22, and those having various structures may be used.

## Claims

1. A sheet-like probe for wafer inspection comprising an insulating sheet, in which a plurality of through-holes each extending in a thickness-wise direction of the insulating sheet have been formed in accordance with a pattern corresponding to a pattern of electrodes to be inspected in all or part of integrated circuits formed on a wafer, which is an object of inspection, and
electrode structures arranged in the respective through-holes in the insulating sheet so as to protrude from both surfaces of the insulating sheet,
wherein each of the electrode structures is formed by linking a front-surface electrode part exposed to a front surface of the insulating sheet and having a diameter greater than a front surface-side opening diameter of the through-hole in the insulating sheet to a back-surface electrode part exposed to a back surface of the insulating sheet and having a diameter greater than a back surface-side opening diameter of the through-hole in the insulating sheet through a short circuit part inserted through into the through-hole in the insulating sheet, and is movable in the thickness-wise direction of the insulating sheet.

2. A probe member for wafer inspection comprising the sheet-like probe for wafer inspection according to claim 1, and an anisotropically conductive connector arranged on a back surface of the sheet-like probe for wafer inspection.

3. A probe card for wafer inspection comprising a circuit board for inspection, on the front surface of which a plurality of inspection electrodes have been formed in accordance with a pattern corresponding to a pattern of electrodes to be inspected in all or part of integrated circuits formed on a wafer, which is an object of inspection, an anisotropically conductive connector arranged on the front surface of the circuit board for inspection, and a sheet-like probe for wafer inspection, which is arranged on the anisotropically conductive connector,
wherein the sheet-like probe for wafer inspection comprises an insulating sheet, in which a plurality of through-holes each extending in a thickness-wise direction of the insulating sheet have been formed in accordance with the pattern corresponding to the pattern of the electrodes to be inspected, and electrode structures arranged in the respective through-holes in the insulating sheet so as to protrude from both surfaces of the insulating sheet, and
wherein each of the electrode structures is formed by linking a front-surface electrode part exposed to a front surface of the insulating sheet and having a diameter greater than a front surface-side opening diameter of the through-hole in the insulating sheet to a back-surface electrode part exposed to a back surface of the insulating sheet and having a diameter greater than a back surface-side opening diameter of the through-hole in the insulating sheet through a short circuit part extending through in the through-hole in the insulating sheet, and is movable in the thickness-wise direction of the insulating sheet.

4. The probe card for wafer inspection according to claim 3, wherein a movable distance of each electrode structure in the thickness-wise direction of the insulating sheet is 5 to 50 µm.

5. The probe card for wafer inspection according to claim 3 or 4, wherein the insulating sheet is composed of a material having a coefficient of linear thermal expansion of at most 3 x 10⁻⁵/K.

6. The probe card for wafer inspection according to any one of claims 3 to 5, wherein the anisotropically conductive connector is composed of a frame plate, in which a plurality of openings have been formed corresponding to electrode regions, in which the electrodes to be inspected in all or part of the integrated circuits formed on the wafer, which is the object of inspection, have been formed, and a plurality of elastic anisotropically conductive films arranged in and supported by the frame plate so as to close the respective openings, and the elastic anisotropically conductive films each have conductive parts for connection arranged in accordance with a pattern corresponding to a pattern of the electrodes to be inspected in the electrode region and formed by causing conductive particles exhibiting magnetism to be contained in an elastic polymeric substance, and an insulating part mutually insulating these conductive parts for connection and composed of the elastic polymeric substance.

7. A wafer inspection apparatus for conducting electrical inspection of each of a plurality of integrated circuits formed on a wafer in a state of the wafer, which comprises
the probe card for wafer inspection according to any one of claims 3 to 6.
